# EUROPEAN PATENT SPECIFICATION

(11) **EP 4 454 020 B1**
(45) Date of publication and mention of the grant of the patent: **19.08.2026**
(21) Application number: 22829653.9
(22) Date of filing: 16.11.2022
(51) Int. Cl.: H10D 30/69, H10D 64/01, H10D 64/68, H10B 51/10, H10B 51/20

(54) **THREE-DIMENSIONAL FERROELECTRIC FIELD EFFECT TRANSISTOR RANDOM ACCESS MEMORY DEVICES AND FABRICATING METHODS THEREOF**
DREIDIMENSIONALE FERROELEKTRISCHE FELDEFFEKTTRANSISTOR-DIREKTZUGRIFFSSPEICHERANORDNUNGEN UND HERSTELLUNGSVERFAHREN DAFÜR
DISPOSITIFS DE MÉMOIRE VIVE À TRANSISTOR À EFFET DE CHAMP FERROÉLECTRIQUE TRIDIMENSIONNELLE ET LEURS PROCÉDÉS DE FABRICATION

(43) Date of publication of application: 30.10.2024
(73) Proprietor: Yangtze Memory Technologies Co., Ltd., Wuhan, Hubei 430000 (CN)
(72) Inventor: ZHAO, DongXue, Wuhan, Hubei 430000 (CN); YANG, Tao, Wuhan, Hubei 430000 (CN); ZHOU, Wenxi, Wuhan, Hubei 430000 (CN); YANG, Yuancheng, Wuhan, Hubei 430000 (CN); XIA, ZhiLiang, Wuhan, Hubei 430000 (CN); HUO, ZongLiang, Wuhan, Hubei 430000 (CN)
(74) Representative: Lippert Stachow Patentanwälte Rechtsanwälte
(86) International application number: PCT/CN2022/132185
(87) International publication number: WO 2024/103281

(56) References cited:
- US-A1- 2020 357 822
- US-A1- 2021 098 490
- US-A1- 2021 375 928
- US-A1- 2021 399 013

## Description

### TECHNICAL FIELD

The present disclosure generally relates to the field of semiconductor technology, and more particularly, to three-dimensional (3D) Ferroelectric Field Effect Transistor Random Access Memory (FeFET RAM) devices, and fabricating methods thereof.

### BACKGROUND

As memory devices are shrinking to smaller die size to reduce manufacturing cost and increase storage density, scaling of planar memory cells faces challenges due to process technology limitations and reliability issues. A three-dimensional (3D) memory architecture can address the density and performance limitation in planar memory cells. US2020/0357822A1 discloses A 3-dimensional vertical memory string array includes highspeed ferroelectric field-effect transistor (FET) cells that are low-cost, low-power, or high-density and suitable for SCM applications. US2021/0399013A1 discloses a memory device with a first tier on a substrate and a second tier on the first tier, wherein the first tier includes a first layer stack, a first gate electrode penetrating through the first layer stack, a first channel layer between the first layer stack and the first gate electrode, and a first ferroelectric layer between the first channel layer and the first gate electrode. US2021/0375928A1 discloses a memory device with a first layer stack and a second layer stack formed successively over a substrate, wherein each of the first and the second layer stacks includes a first metal layer, a second metal layer, and a first dielectric material between the first and the second metal layers; a second dielectric material between the first and the second layer stacks; a gate electrode extending through the first and the second layer stacks, and through the second dielectric material; a ferroelectric material extending along and contacting a sidewall of the gate electrode; and a channel material, where a first portion and a second portion of the channel material extend along and contact a first sidewall of the first layer stack and a second sidewall of the second layer stack, respectively, where the first portion and the second portion of the channel material are separated from each other.

US 2021/098490 A1 figure 1 A-1Q shows a ferroelectric memory with vertical back gate and horizontal channel between source and drain regions, which are vertically connected as source and drain columns; and the associated process.

In a 3D NAND memory, memory cells can be programmed for data storage based on charge-trapping technology. The storage information of a memory cell depends on the amount of charge trapped in a storage layer. Although 3D NAND memory can be high density and cost-effective, it suffers from low write speed and high power consumption at system level due to required periphery (e.g., charge pumps). On the other hand, phase change memory generally has large leakage current and high power consumption. Therefore, a need exists to develop a new high-speed and high-density storage class memory (SCM).

Ferroelectric Field Effect Transistor Random Access Memory (FeFET RAM) is a high performance and low-power non-volatile memory that can combine the benefits of conventional non-volatile memories (e.g., Flash and EEPROM) and high-speed RAM (e.g., SRAM and DRAM). FeFET RAM can outperform existing memories like EEPROM and Flash with less power consumption, faster response, and greater endurance to multiple read- and-write operations. The traditional planar FeFET RAM is difficult to scale down.

Therefore, it is desired to develop a new 3D architecture of FeFET RAM.

### BRIEF SUMMARY

Implementations of 3D FeFET RAM devices and fabricating methods are described in the present disclosure.

The invention provides a ferroelectric memory device according to claim 1, and a method for forming a ferroelectric memory device according to claim 12. Preferred embodiments are defined in the dependent claims.

### BRIEF DESCRIPTION OF THE DRAWINGS

The accompanying drawings, which are incorporated herein and form a part of the specification, illustrate implementations of the present disclosure and, together with the description, further serve to explain the principles of the present disclosure and to enable a person skilled in the pertinent art to make and use the present disclosure.
FIG. 1 illustrates an exemplary electric polarization of a ferroelectric material as a function of applied electrical field, according to some implementations of the present disclosure.
FIG. 2 illustrates a schematic cross-section of a 3D FeFET RAM cell, according to some examples not forming part of the invention.
FIGs. 3A and 3B illustrate charge distribution in the memory film of a 3D FeFET RAM cell during programming and erasing operations, respectively, in accordance with some some examples not forming part of the invention.
FIG. 4 illustrates a perspective view of a portion of an exemplary 3D memory array structure of a FeFET RAM, in accordance with some implementations of the present disclosure.
FIGs. 5A and 5B illustrate schematic top-down views of exemplary 3D FeFET RAM cells, in accordance with some implementations of the present disclosure.
FIG. 6A illustrates a schematic top-down view of a pattern design of an exemplary 3D memory array structure of a FeFET RAM, in accordance with some implementations of the present disclosure.
FIG. 6B illustrates a schematic circuit diagram corresponding to the pattern design of the exemplary 3D memory array structure as shown in FIG. 6A, in accordance with some implementations of the present disclosure.
FIG. 7 illustrates a schematic circuit diagram of another pattern design of another exemplary 3D memory array structure of a FeFET RAM, in accordance with some other implementations of the present disclosure.
FIG. 8A illustrates a schematic top-down view of a pattern design of another exemplary 3D memory array structure of a FeFET RAM, in accordance with some other implementations of the present disclosure.
FIG. 8B illustrates a schematic circuit diagram corresponding to the pattern design of the exemplary 3D memory array structure as shown in FIG. 8A, in accordance with some other implementations of the present disclosure.
FIG. 9 illustrates a schematic circuit diagram of another pattern design of another exemplary 3D memory array structure of a FeFET RAM, in accordance with some other implementations of the present disclosure.
FIG. 10 illustrates a flow diagram of an exemplary method for forming a 3D memory structure of a FeFET RAM, according to some implementations of the present disclosure.
FIGs. 11-17B illustrate schematic cross-sectional views and/or top-down views of an exemplary 3D memory structure at certain fabricating stages of the method shown in FIG. 10, according to some implementations of the present disclosure.
FIG. 18 illustrates a flow diagram of an exemplary method for forming exemplary source and drain connections of a 3D memory structure of a FeFET RAM, according to some implementations of the present disclosure.
FIGs. 19-21 illustrate schematic cross-sectional views and/or top-down views of an exemplary 3D memory structure at certain fabricating stages of the method shown in FIG. 18, according to some implementations of the present disclosure.
FIG. 22 illustrates another flow diagram of another exemplary method for forming exemplary source and drain connections of a 3D memory structure of a FeFET RAM, according to some implementations of the present disclosure.
FIGs. 23-27 and 28A-28C illustrate schematic cross-sectional views and/or top-down views of an exemplary 3D memory structure at certain fabricating stages of the method shown in FIG. 22, according to some implementations of the present disclosure.
FIG. 29 illustrates a perspective view of a 3D FeFET RAM, according to some implementations of the present disclosure.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements. The drawing in which an element first appears is indicated by the leftmost digit(s) in the corresponding reference number.

Implementations of the present disclosure will be described with reference to the accompanying drawings.

### DETAILED DESCRIPTION

Although specific configurations and arrangements are discussed, it should be understood that this is done for illustrative purposes only. A person skilled in the pertinent art will recognize that other configurations and arrangements can be used without departing from the spirit and scope of the present disclosure. It will be apparent to a person skilled in the pertinent art that the present disclosure can also be employed in a variety of other applications.

It is noted that references in the specification to "one implementation," "an implementation," "an example implementation," "some implementations," etc., indicate that the implementation described can include a particular feature, structure, or characteristic, but every implementation can not necessarily include the particular feature, structure, or characteristic. Moreover, such phrases do not necessarily refer to the same implementation. Further, when a particular feature, structure or characteristic is described in connection with an implementation, it would be within the knowledge of a person skilled in the pertinent art to affect such feature, structure or characteristic in connection with other implementations whether or not explicitly described.

In general, terminology can be understood at least in part from usage in context. For example, the term "one or more" as used herein, depending at least in part upon context, can be used to describe any feature, structure, or characteristic in a singular sense or can be used to describe combinations of features, structures or characteristics in a plural sense. Similarly, terms, such as "a," "an," or "the," again, can be understood to convey a singular usage or to convey a plural usage, depending at least in part upon context. In addition, the term "based on" can be understood as not necessarily intended to convey an exclusive set of factors and may, instead, allow for existence of additional factors not necessarily expressly described, again, depending at least in part on context.

It should be readily understood that the meaning of "on," "above," and "over" in the present disclosure should be interpreted in the broadest manner such that "on" not only means "directly on" something, but also includes the meaning of "on" something with an intermediate feature or a layer there between. Moreover, "above" or "over" not only means "above" or "over" something, but can also include the meaning it is "above" or "over" something with no intermediate feature or layer there between (i.e., directly on something).

Further, spatially relative terms, such as "beneath," "below," "lower," "above," "upper," and the like, can be used herein for ease of description to describe one element or feature's relationship to another element(s) or feature(s) as illustrated in the figures. The spatially relative terms are intended to encompass different orientations of the device in use or process step in addition to the orientation depicted in the figures. The apparatus can be otherwise oriented (rotated 90 degrees or at other orientations) and the spatially relative descriptors used herein can likewise be interpreted accordingly.

As used herein, the term "substrate" refers to a material onto which subsequent material layers are added. The substrate includes a "top" surface and a "bottom" surface. The top surface of the substrate is typically where a semiconductor device is formed, and therefore the semiconductor device is formed at a top side of the substrate unless stated otherwise. The bottom surface is opposite to the top surface and therefore a bottom side of the substrate is opposite to the top side of the substrate. The substrate itself can be patterned. Materials added on top of the substrate can be patterned or can remain unpatterned. Furthermore, the substrate can include a wide array of semiconductor materials, such as silicon, germanium, gallium arsenide, indium phosphide, etc. Alternatively, the substrate can be made from an electrically non-conductive material, such as a glass, a plastic, or a sapphire wafer.

As used herein, the term "layer" refers to a material portion including a region with a thickness. A layer has a top side and a bottom side where the bottom side of the layer is relatively close to the substrate and the top side is relatively away from the substrate. A layer can extend over the entirety of an underlying or overlying structure, or can have an extent less than the extent of an underlying or overlying structure. Further, a layer can be a region of a homogeneous or inhomogeneous continuous structure that has a thickness less than the thickness of the continuous structure. For example, a layer can be located between any set of horizontal planes between, or at, a top surface and a bottom surface of the continuous structure. A layer can extend horizontally, vertically, and/or along a tapered surface. A substrate can be a layer, can include one or more layers therein, and/or can have one or more layer thereupon, there above, and/or there below. A layer can include multiple layers. For example, an interconnect layer can include one or more conductive and contact layers (in which contacts, interconnect lines, and/or vertical interconnect accesses (VIAs) are formed) and one or more dielectric layers.

In the present disclosure, for ease of description, "tier" is used to refer to elements of substantially the same height along the vertical direction. For example, a word line and the underlying gate dielectric layer can be referred to as "a tier," a word line and the underlying insulating layer can together be referred to as "a tier," word lines of substantially the same height can be referred to as "a tier of word lines" or similar, and so on.

As used herein, the term "nominal/nominally" refers to a desired, or target, value of a characteristic or parameter for a component or a process step, set during the design phase of a product or a process, together with a range of values above and/or below the desired value. The range of values can be due to slight variations in manufacturing processes or tolerances. As used herein, the term "about" indicates the value of a given quantity that can vary based on a particular technology node associated with the subject semiconductor device. Based on the particular technology node, the term "about" can indicate a value of a given quantity that varies within, for example, 10-30% of the value (e.g., ±10%, ±20%, or ±30% of the value).

In the present disclosure, the term "horizontal/horizontally/lateral/laterally" means nominally parallel to a lateral surface of a substrate, and the term "vertical" or "vertically" means nominally perpendicular to the lateral surface of a substrate.

As used herein, the term "3D memory" refers to a three-dimensional (3D) semiconductor device with vertically oriented strings of memory cell transistors (referred to herein as "memory strings") on a laterally-oriented substrate so that the memory strings extend in the vertical direction with respect to the substrate.

While floating gate memory cells and charge trapping technology have been traditionally utilized in flash memories, Ferroelectric Field Effect Transistor random access memories (FeFET RAMs) can provide low-voltage and low-power operation, fast write, non-volatility, and high cycling endurance.

Ferroelectricity is a property observed in non-centrosymmetric dielectric crystals that show a spontaneous electric polarization, where the direction of polarization can be changed by an externally applied electric field. In a ferroelectric material, some atoms in the unit cell are misplaced to create a permanent electric dipole due to the distribution of electric charge. A macroscopic manifestation of the charge separation is the surface charge of the ferroelectric material, described by an electric polarization P. Typical ferroelectric materials, such as Lead Zirconate Titanate (PZT), Strontium Bismuth Tantalate (SrBi₂Ta₂O₉ or SBT), Barium Titanate (BaTiO₃) and PbTiO₃, have perovskite-type crystal structure, where the cation in the center of the unit cell has two positions, both being stable low-energy states. The two low-energy states correspond to two opposite directions of the electric dipole. Under an external electric field, the cation can move in the direction of the electric field. Thus, by applying an external electric field across the crystal, cation in the unit cell can be moved from one low-energy position to another low-energy position and the direction of the electric dipole can be flipped if the applied electric field is high enough. As a result, the electric polarization P in the ferroelectric material can be aligned with the direction of the external electric field.

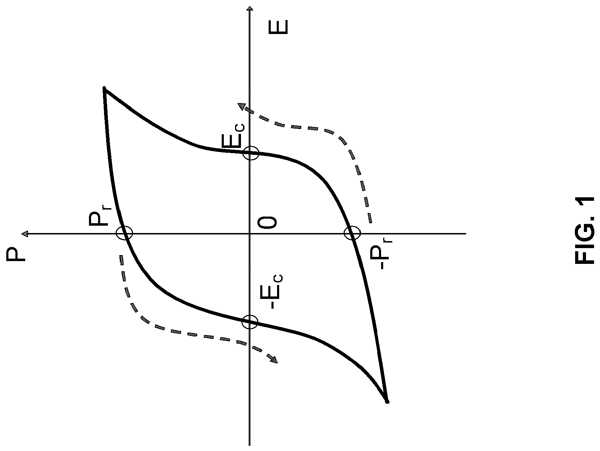

FIG. 1 illustrates an exemplary electric polarization P of a ferroelectric material as a function of applied electrical field E, where a remnant polarization Pᵣ (or a reversed remnant polarization -Pᵣ) of the ferroelectric material can be measured at zero external electric field. As shown in FIG. 1, the change of the electric polarization with an applied electric field follows a hysteresis loop. When a positive electric field is applied across the ferroelectric material, it is polarized positively until its electric polarization P changes linearly with applied electric field E.

When the external electric field is removed, the electric polarization (also referred to polarization in this disclosure) in the ferroelectric material does not disappear. When the external electric field is removed after the ferroelectric material has been fully polarized, the remaining polarization in the ferroelectric material is the remnant polarization Pᵣ.

Applying a reverse electric field does not un-polarize the ferroelectric material until it reaches the reversed coercive field -E_{c}. Here, the negative sign shows the reversed direction of the electric field, and the magnitude is represented by E_{c}, where at the left-side of the loop the polarization P reaches zero. Continuingly increasing the magnitude of the negative electric field, the ferroelectric material can be fully polarized in the negative direction. When the negative electric field is removed, the ferroelectric material has the reversed remnant polarization -Pᵣ, in the negative direction.

Applying a positive electric field from then on, and passing the coercive field E_{c} in the positive direction, the polarization in the ferroelectric material can be flipped to positive direction again until it is fully polarized to follow linearly with the electric field. The hysteresis loop can be repeated numerous times to alter the polarization direction of the ferroelectric, often more than 10¹⁶ cycles depending on the material.

The ferroelectric polarization is non-volatile in that once the polarization is generated, the external electric field is unable to change the polarization direction until the magnitude of the electric field reaches a threshold (i.e., the coercive field E_{c} or reversed coercive field -E_{c}). A FeFET RAM cell uses the polarization reversal or switching effect and stores digital bits "0" and "1" according to the directions of the spontaneous polarization.

In a FeFET RAM, the ferroelectric material can be implemented as a capacitor, consisting of a thin ferroelectric film sandwiched in between two conductive electrodes. To write, a programming voltage Vₚ can be applied to one end of the capacitor and the other end of the capacitor can be grounded. The polarization direction of the ferroelectric material can be switched when the programming voltage Vₚ changes from positive to negative or vice versa. And the capacitor can be set or reset to a logic state of " 1" or "0." Here, the programming voltage Vₚ needs to be higher than a coercive voltage V_{c}, where V_{c} *= d_{f} × E_{c}* and d_{f} is the thickness of the ferroelectric material. For example, the coercive field E_{c} of an HfO₂-based ferroelectric material can be about 1 MV/cm, while the coercive field E_{c} of PZT or SBT can be about 50 kV/cm. While large coercive field E_{c} can provide large memory window (about 2·Ec) between two memory states, smaller coercive voltage V_{c} can reduce operation power and energy consumption. In some implementations, the thickness d_{f} of the HfO₂-based ferroelectric material can be scaled down to a range between 5nm and 50 nm. Accordingly, the coercive voltage V_{c} of the HfO₂-based ferroelectric material can be in a range between 0.5 V and 5 V. In some implementations, the programming voltage Vₚ can have a magnitude in a range between about 3V to about 10V. In some implementations, the programming voltage Vₚ can be a voltage pulse with a duration in a range between 10 ns to 100µs.

A FeFET random access memory can be non-volatile and can provide high performance and low-power. However, planar FeFET RAM is difficult to scale down in order to increase storage capacity. By replacing the charge trapping storage layer in a 3D NAND flash memory with a ferroelectric material (e.g., Si:HfO₂), a FeFET RAM with a similar 3D architecture can realize scalable dimensions without performance penalty. However, due to limited source and drain contact area in a 3D FeFET RAM architecture, it is challenging to lead the source and drain separately to realize individual access of each memory cell. Therefore, it is desired to develop a new 3D architecture of FeFET RAM.

In a three-dimensional (3D) FeFET RAM, a memory cell can be formed by using a FeFET, where the storage information depends on polarization directions of the ferroelectric material in a storage layer (e.g., the gate dielectric of the transistor).

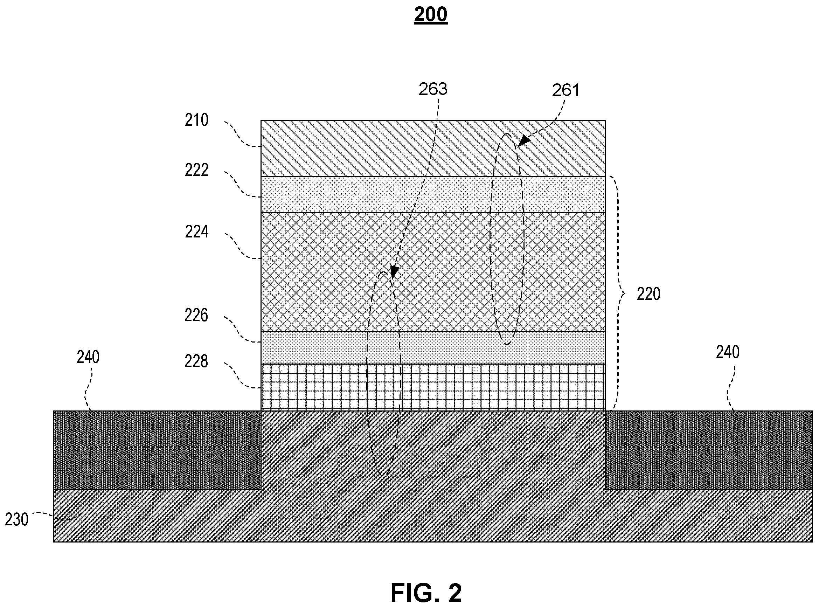

FIG. 2 illustrates a schematic cross-section of a 3D FeFET RAM cell 200, according to some implementations of the present disclosure. The 3D FeFET RAM cell 200 can include a control gate 210, a memory film 220, a channel layer 230, and source/drain electrodes 240.

In the 3D FeFET RAM cell 200, the memory film 220 can be located between the control gate 210 and the channel layer 230, and can include a barrier layer 222, a ferroelectric film 224, and an electrode layer 226, and an interface layer 228.

In some implementation, the barrier layer 222 is located between the control gate 210 and the ferroelectric film 224. The control gate 210 can be a metal layer or a polycrystalline silicon layer. In one implementation, a thickness of the control gate can be no less than 10 nm. The barrier layer 222 can be used to block the interactions between the ferroelectric film 224 and the control gate 210. The barrier layer can include titanium nitride (TiN), silicon oxide (SiO₂), silicon nitride (Si₃N₄), silicon oxynitride (Si₂O₂N), high-k dielectric materials (e.g., HfO₂, Al₂O₃), and/or any combination thereof. The barrier layer can be formed by any suitable physical vapor deposition (PVD) or chemical vapor deposition (CVD). In one implementation, a thickness of the barrier layer 222 can be no more than 5 nm.

In some implementations, the ferroelectric film 224 can include a high-k (i.e., high dielectric constant) dielectric material, which can include transitional metal oxides such as hafnium-zirconium oxide (HZO), hafnium oxide (HfO₂), aluminum oxide (Al₂O₃), Zirconium oxide (ZrO₂), titanium oxide (TiO₂), niobium oxide (Nb₂O₅), tantalum oxide (Ta₂O₃), tungsten oxide (WO₃), molybdenum oxide (MO₃), vanadium oxide (V₂O₃), lanthanum oxide (La₂O₃), and/or any combination thereof. In some implementations, to improved ferroelectric property, the high-k dielectric material can be doped. For example, the ferroelectric film 224 can be HZO or HfO₂ doped with silicon (Si), (Yttrium) Y, Gadolinium (Gd), Lanthanum (La), Zircomium (Zr) or Aluminum (Al), or any combination thereof. In some implementations, the ferroelectric film 224 can include Zirconate Titanate (PZT), Strontium Bismuth Tantalate (SrBi₂Ta₂O₉), Barium Titanate (BaTiO₃), PbTiO₃, and BLT ((Bi,La)4Ti₃O₁₂), or any combination thereof.

In some implementations, the ferroelectric film 224 can be disposed by chemical vapor deposition (CVD), for example, metal organic chemical vapor deposition (MOCVD), low pressure chemical vapor deposition (LPCVD), plasma enhanced chemical vapor deposition (PECVD), high-density plasma chemical vapor deposition (HDP-CVD), etc. The ferroelectric film 224 can also be disposed by atomic layer deposition (ALD), sputtering, evaporating, or any combination thereof. In one implementation, a thickness of the ferroelectric film 224 can be at least 5 nm.

In some implementations, the interface layer 228 can be located between the ferroelectric film 224 and the channel layer 230. The interface layer 228 can be used to reduce the possibility of material intermixing between the ferroelectric film 224 and the channel layer 230. In this example, the effective gate dielectric of the FeFET is the combination of the ferroelectric film 224 and the interface layer 228. Thinner effective gate dielectric can provide better control of the channel layer 230 from the control gate 210. In some implementation, the interface layer 228 can be silicon oxide, silicon nitride, silicon oxynitride, high-k dielectric material (e.g., HfO₂, HfAlO, Al₂O₃), and/or any combination thereof. The interface layer 228 can be disposed by any suitable film deposition technique such as ALD, CVD, sputtering, evaporation, and/or any combination thereof. The interface layer 228 can also be formed by oxidation, nitridation, and/or a combination thereof. In one implementation, a thickness of the interface layer 228 can be no more than 3 nm.

In some implementations, the memory film 220 can further include an electrode layer 226 between the ferroelectric film 224 and the interface layer 228. As such, the control gate 210, the ferroelectric film 224, and the electrode layer 226 forms a metal-insulator-metal (MIM) capacitor 261 that is in series with a floating gate transistor (FG-MOSFET) 263 where the electrode layer 226 functions as a floating gate, the interface layer 228 functions as a gate dielectric and the channel layer 230 functions as a channel.

In some implementations, the channel layer 230 can include amorphous silicon, polycrystalline silicon, monocrystalline silicon, and/or any combination thereof. The channel layer 230 can be disposed by any suitable thin film deposition technique such as ALD, CVD, sputtering, etc. In some implementations, portions of the channel layer 230 can be doped to form the source/drain electrode 240 on each side of the control gate 210 respectively. In some other implementations, the source/drain electrode 240 can be metal layers formed on the channel layer 230. In some implementations, a thickness of the channel layer 230 is not less than 5 nm. ,

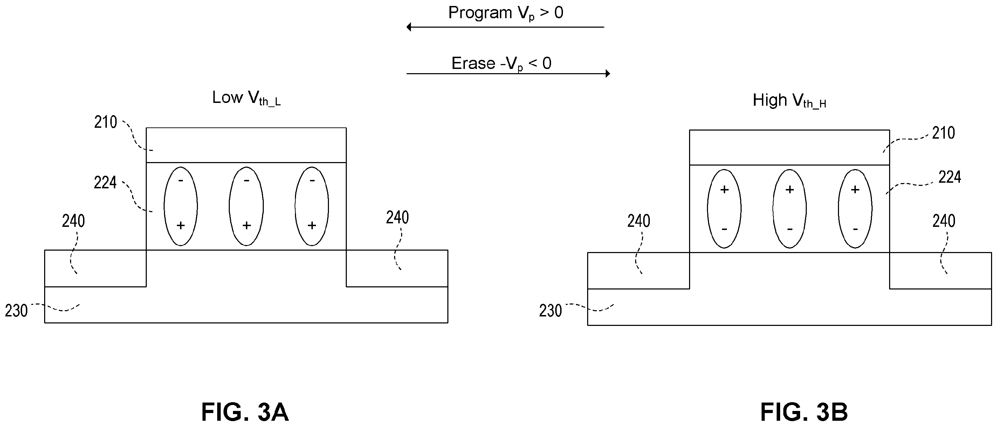

Referring to FIGs. 3A and 3B, charge distribution in the memory film of a 3D FeFET RAM cell during programing and erasing operations are illustrated, respectively, in accordance with some implementations of the present disclosure. It is noted that, the barrier layer 222, the electrode layer 226, and the interface layer 228 of the 3D FeFET RAM cell are omitted in FIGs. 3A and 3B for simplicity.

During a programing operation as shown in FIG. 3A, the programming voltage Vₚ applied on the control gate 210 provides a positive voltage across the ferroelectric film 224 that is larger than the coercive voltage (Vₚ>V_{c}), the ferroelectric film 224 can have the positive remnant polarization Pᵣ, with a direction pointing from the control gate 210 to the channel layer 230. As a result, top surface charges near the control gate 210 are negative and bottom surface charges near the channel layer 230 are positive. The positive bottom surface charges near the channel layer 230 can lower the threshold voltage Vₜₕ of the transistor. Therefore, the 3D FeFET RAM cell can be programmed to a low threshold voltage V_{th_L}, and set to a logic state of "1."

During an erasing operation as shown in FIG. 3B, the erase voltage -Vₚ (e.g., negative voltage) is applied on the control gate 210 with a magnitude larger than the reversed coercive voltage (i.e., |-Vₚ|>|-V_{c}|), the ferroelectric film 224 can be negatively polarized to have the reversed remnant polarization -Pᵣ, with a direction pointing from the channel layer 230 to the control gate 210. The top surface charges near the control gate 210 are positive and bottom surface charges near the channel layer 230 are negative. The negative bottom surface charges near the channel increase the threshold voltage Vₜₕ of the transistor. Therefore, the 3D FeFET RAM cell can be reset to a high threshold voltage V_{th_H}, and to a logic state of "0."

It is noted that the coercive field E_{c}, the coercive voltage V_{c}, the programming voltage Vₚ and the remnant polarization Pᵣ are not necessarily be symmetric around zero. Positive and negative values can have different magnitude. To simplify discussion below, it is assumed that the magnitudes are the same in the reversed direction. A person of ordinary skill in the art should be able to apply the methods below for general conditions.

As discussed above, by applying suitable voltage pulses on the control gate 210, polarization direction of the ferroelectric film 224 can be switched and threshold voltage of the 3D FeFET RAM cell can be changed, which impact the conductance of the channel layer 230 and the on/off state of the 3D FeFET RAM cell. The logic states (or the storage data) of the 3D FeFET RAM cell can be determined accordingly.

In some implementations, during a reading operation (not shown in FIGs. 3A and 3B), by applying a reading voltage V_{read} on the control gate 210, the conductance of the channel layer 230 can be measured from the source/drain electrodes 240 of the 3D FeFET RAM cell. The logic state or the threshold voltage of the 3D FeFET RAM cell can be verified. Compared with traditional 3D NAND where the memory cells are operated based on charge trapping in the memory film, the 3D FeFET RAM cell can be controlled by polarization in the ferroelectric film 224 instead.

It is noted that, the electrode layer 226 shown in FIG. 2 is optional. During an operation of the 3D FeFET RAM cell, the voltage of the electrode layer 226 is determined by the number of bottom surface charges of the ferrorelectric film 224. By switching the polarization direction in the ferroelectric film 224, the number of bottom surface charges can be changed, and the voltage of the electrode layer 226 can be changed accordingly. Thus, the threshold voltage of the 3D FeFET RAM cell can be changed. The electrode layer 226 in the 3D FeFET RAM cell can provide similar functions as a floating gate in a NAND memory, where the voltage of the electrode layer 226 can be controlled by the polarization of the ferroelectric film 224. The applied voltage on the control gate 210 is divided between the MIM capacitor 261 and the FG-MOSFET 263. As a result, relatively larger voltage is necessary to switch the polarization of the ferroelectric film 224. To reduce writing voltage, a thinner ferroelectric film 224 can be used in some implementations. The MIM capacitor 261 can have larger capacitor from scaling the thickness of the ferroelectric film 224 such that a larger portion of the applied voltage can be dropped across the MIM capacitor 261.

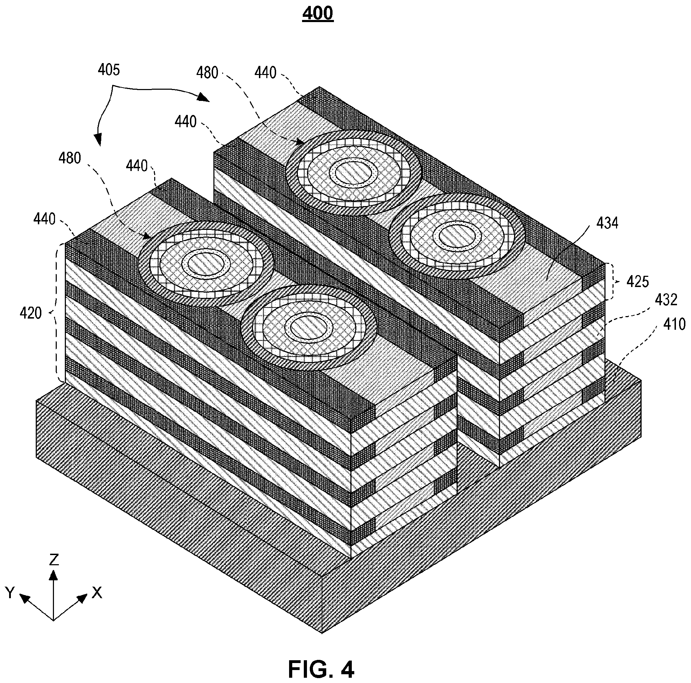

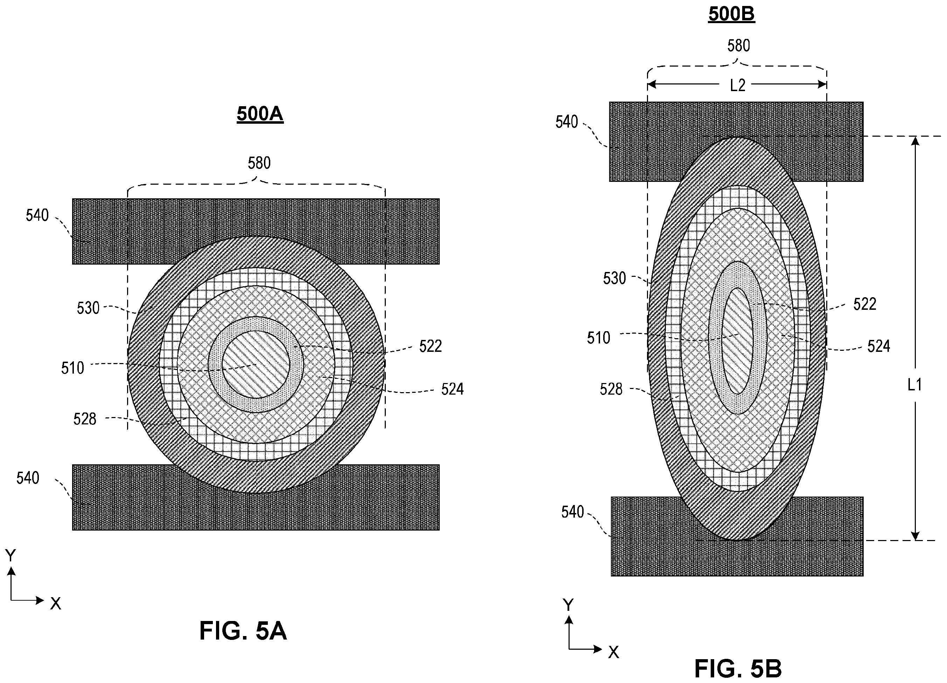

Referring to FIG. 4, a schematic diagram of a portion of an exemplary 3D memory array structure of a FeFET RAM is illustrated in accordance with some implementations of the present disclosure. Referring to FIGs. 5A and 5B, schematic top-down views of exemplary 3D FeFET RAM cells are illustrated in accordance with some implementations of the present disclosure.

As shown in FIG. 4, memory array structure 400 includes a substrate 410, an film stack 420 on the substrate 410. In some implementations, the substrate 410 can be any suitable semiconductor substrate having any suitable structure, such as a monocrystalline single-layer substrate, a polycrystalline silicon (polysilicon) single-layer substrate, a polysilicon and metal multi-layer substrate, etc. In some implementations, the substrate 410 can be removed in subsequent processes.

In some implementations, memory blocks 405 can be formed by separating the film stack 420 using slit structures extending along Y direction, which is parallel to the top surface of the substrate 410. In the vertical direction (e.g., Z direction) perpendicular to the top surface of the substrate 410, the film stack 420 can include functional tiers 425 stacked along the Z direction. Each functional tier (or "tier") 425 can include a first dielectric layer 432, a second dielectric layer 434, and a conductive layer 440. The conductive layer 440 and the second dielectric layer 434 are both on the first dielectric layer 432. The conductive layer 440 can be located on both sides of the second dielectric layer 434 in X direction, which is parallel to the top surface of the substrate 410 and is perpendicular to the Y direction. That is, the second dielectric layer 434 is sandwiched between the conductive layer 440 in the X direction.

As shown in FIG. 4, each memory block 405 can include a row of memory strings each including a channel hole extending through film stack 420. The channel hole can be formed by removing portions of the first dielectric layer 432, the second dielectric layer 434, and the conductive layer 440, such that inner sidewalls of the first dielectric layer 432, the second dielectric layer 434, and the conductive layer 440 in each functional tier 425 are exposed by the channel hole. A channel structure 480 can be formed in each channel hole. In some implementations, the channel structure 480 can include a channel layer on the sidewall of the channel hole, a memory film on the sidewall of the channel layer, and a core control gate surrounded by the memory film. As such, the channel structure 480 and the conductive layers 440 in the film stack 420 can form a column of 3D FeFET RAM cells stacked in the vertical direction, where the column of the 3D FeFET RAM cells along the vertical direction forms a memory string.

It is noted that in FIG. 4, for illustrative purposes, four tiers of functional tiers 425 are shown for simplicity. In this example, each memory string can include four 3D FeFET RAM cells. In some implementations, the number of the 3D FeFET RAM cells in each memory string can be larger than 50 to increase storage capacity. The memory array structure 400 can also include other suitable structures not shown in FIG. 4 for simplicity.

As shown in FIGs. 5A and 5B, the 3D FeFET RAM cells 500A and 500B can each include a control gate 510, a barrier layer 522, a ferroelectric film 524, an interface layer 528, a channel layer 530, and source/drain electrodes 540, which are similar to the control gate 210, the barrier layer 222, the ferroelectric film 224, the interface layer 228, the channel layer 230, and the source/drain electrodes 240 shown in FIG. 2, respectively. It is noted that, the source electrode and the drain electrode 540 can be formed by the conductive layer 440 in FIG. 4 and can be separated by a second dielectric layer (e.g., the second dielectric layer 434 as shown in FIG. 4) that is omitted in FIGs. 5A and 5B for simplicity.

In some implementations as shown in FIG. 5A, the cross section of the channel hole in the horizontal X-Y plane is a circular shape. That is, the control gate 510, the barrier layer 522, the ferroelectric film 524, the interface layer 528, and the channel layer 530 can form a channel structure 580 having a cylinder shape and being sandwiched by the source/drain electrodes 540. Specifically, the channel layer 530 can be in physical contact with the source/drain electrodes 540, and can encircle the interface layer 528 in the cross-sectional X-Y plane. The interface layer 528 can encircle the ferroelectric film 524 in the cross-sectional X-Y plane. The ferroelectric film 524 can encircle the barrier layer 522 in the cross-sectional X-Y plane. The barrier layer 522 can encircle the control gate 510 in the cross-sectional X-Y plane. In one implementation, the channel structures 480 shown in FIG. 4 can have circular shapes in the X-Y plane, similar to the channel structures 580 shown in FIG. 5A.

In some other implementations as shown in FIG. 5B, the cross section of the channel hole in the horizontal X-Y plane is an oval shape. That is, a ratio between a long diameter L1 of the channel structure 580 and a short diameter L2 of the channel structure 580 is larger than 1. In some implementations, the long diameter L1, the short diameter L2, and the ratio L1/L2 can be determined based on a total number of 3D FeFET RAM cells in each memory string. For example, the sizes of the long diameter L1 and the short diameter L2, and the ratio L1/L2 can be increased when total number of 3D FeFET RAM cells in each memory string is increased. In a specific example, when there are 60 tiers of 3D FeFET RAM cells in each memory string. In some implementations, the long diameter L1 of the channel structure 580 can provide an increased contacting area and/or multiple contacting area options for landing a control gate contact. As such, the gate control ability of the 3D memory array structure can be enhanced. In one implementation, the channel structures 480 shown in FIG. 4 can have oval shapes in the X-Y plane, similar to the channel structures 580 shown in FIG. 5B.

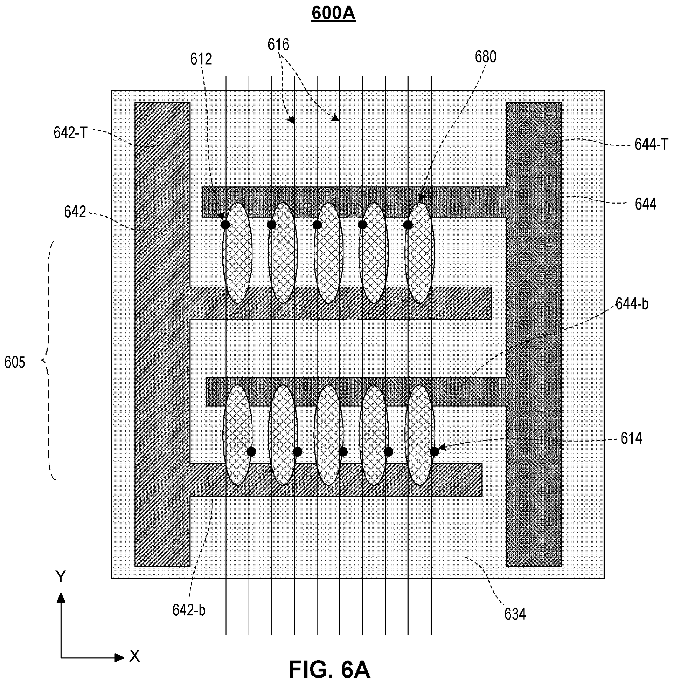

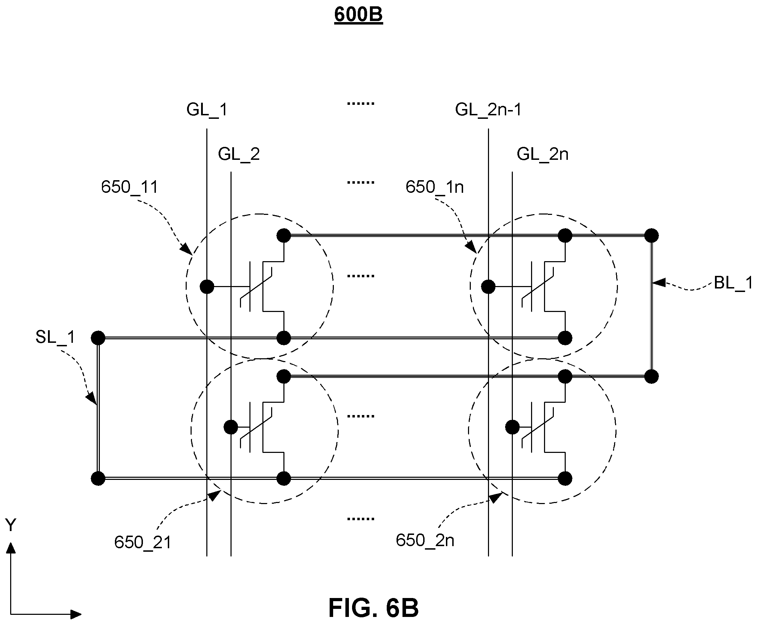

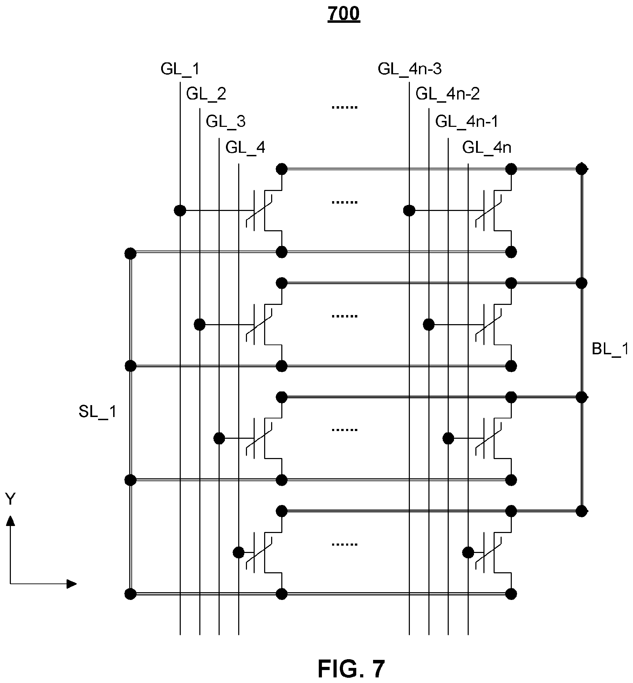

Referring to FIG. 6A, a schematic top-down view of a pattern design of an exemplary 3D memory array structure of a FeFET RAM is illustrated in accordance with some implementations of the present disclosure. FIG. 6B illustrates a schematic circuit diagram corresponding to the pattern design of the exemplary 3D memory array structure as shown in FIG. 6A. FIG. 7 illustrates a schematic circuit diagram of another pattern design of another exemplary 3D memory array structure of a FeFET RAM in accordance with some other implementations of the present disclosure.

As shown in FIG. 6A, in the X-Y plane, the 3D memory array structure 600A can include channel structures 680 arranged in an array form. The channel structures 680 can each have an oval shape in the cross section in the horizontal X-Y plane, similar to the channel structures 580 shown in FIG. 5B. The long diameter of each channel structure 680 can be along the Y direction, and the short diameter of each channel structure 680 can be along the X direction. In the Y direction, two rows of channel structures 680 can be arranged in a memory block 605 (similar to the memory block 405 in FIG. 4) that share a common source line 642 and a common bit line 644. It is noted that in FIG. 6A, for illustrative purposes, five channel structures 680 are shown in each row for simplicity. In some implementations, the number "n" of the channel structures 680 in each row can be larger than five to increase storage capacity. It is also noted that the common source lines 642 and the common bit lines 644 at different tiers (in the Z direction) are electrically isolated from each other, for example, by the first dielectric layer 432 (see FIG. 4).

As shown in FIG. 6A, the common source line 642 and the common bit line 644 can each include a trunk line (also referred as "common source trunk line" 642-T and "common bit trunk line" 644-T) extending along the Y direction and located on each side of the array of the channel structures 680 respectively, and also can each include branch lines (also referred as "common source branch lines" 642-b and "common bit branch lines" 644-b) located between rows of the channel structures 680 in an alternatingly interlaced manner. In some implementations, each branch line of the common source line 642 or the common bit line 644 can have a single strip shape and extend along the X direction. That is, the common source line 642 and the common bit line 644 can each have a comb shape with the branch lines 642-b, 644-b interlaced with each other. In one implementation, each common source branch line 642-b is adj acent to two common bit branch lines 644-b, and each common bit branch line 644-b is adjacent to two common source branch lines 642-b. In one implementation, the common source line 642 and the common bit line 644 can be formed by the conductive layer 440 in FIG. 4 and can be separated by a second dielectric layer 634 that is similar to the second dielectric layer 434 in FIG. 4.

In the X-Y plane, each row of channel structures 680 are arranged between adjacent branch lines of the common source line 642 and the common bit line 644. And, there are one common source branch line 642-b and one common bit branch line 644-b between adjacent rows of the channel structures 680. For example, second ends of the channel structures 680 in each row can be commonly in contact with one branch line of the common source line 642, and first ends of the channel structures 680 in each row can be commonly in contact with one adjacent branch line of the common bit line 644. The first end and the second end of the channel structure 680 are on opposite sides of the channel structure 680 in the Y direction. As such, at a same tier, the channel layers of the channel structures 680 (similar to the channel layer 530 of the channel structure 580 in FIG. 5B) in a same row can be in physical contact with the common source line 642 and the common bit line 644.

Further, as shown in FIG. 6A, the 3D memory array structure 600A can include gate lines 616 arranged parallel with each other and extending along the Y direction. Since there are two rows of channel structures 680 in each memory block 605, two gate lines 616 can be arranged for each column of channel structures 680, wherein one gate line 616 can be connected to the control gate of the channel structure 680 (similar to the control gate 510 of the channel structure 580 in FIG. 5B) in the first row via a first control gate contact 612, and the other gate line 616 can be connected to the control gate of the channel structure 680 in the second row via a second control gate contact 614. As discussed above in connection with FIG. 5B, the oval shape of the channel structure 680 in the X-Y plane can provide an increased contacting area and/or multiple contacting area options for landing the first control gate contact 612 or the second control gate contact 614.

FIG. 6B illustrates a schematic circuit diagram of one exemplary memory sub-block 600B of the 3D memory array structure of a FeFET RAM according to the pattern design as shown in FIG. 6A. It is noted that, the schematic circuit diagram of a memory sub-block 600B corresponds to one tier of 3D FeFET RAM cells in the 3D memory array structure in the X-Y plane. For example, the memory block 405 (perspective view in FIG. 4) and the memory block 605 (top-down view in FIG. 6A) can include tiers of memory sub-block 600B stacked in the Z direction.

As shown in FIG. 6B, the memory sub-block 600B of the 3D memory array structure can include two rows of Ferroelectric Field Effect Transistors (FeFETs), wherein the first row includes number "n" of FeFET RAM cells 650_11, ..., 650_1n and the second row includes number "n" of FeFET RAM cells 650_21, ..., 650_2n, where "n" can be any suitable whole number. The first and second rows of FeFET RAM cells share a common source line SL_1 (similar to the common source line 642 in FIG. 6A), and share a common bit line BL_1 (similar to the common bit line 644). A number "2n" of gate lines GL_1, ..., GL_2n can each be connected to a corresponding FeFET RAM cell, such that the number "2n" of FeFET RAM cells in the memory sub-block 600B can be independently controlled.

It is noted that for a same channel structure 680 in FIG. 6A, the control gate and a corresponding gate line 616, control a plurality of tiers of FeFET RAM cells stacked in the Z direction. As shown in FIG. 6B, the FeFET RAM cells (650_11, ..., 650_2n) in each tier (i.e., in the same memory sub-block) can share a common source line and a common bit line. However, the common source lines for the FeFET RAM cells at different tiers (i.e., in different memory sub-blocks) can be electrically isolated from each other, for example, by the first dielectric layer 432 (see FIG. 4). Similarly, the common bit lines for the FeFET RAM cells in different tiers (i.e., in different memory sub-blocks) can also be electrically isolated from each other, for example, by the first dielectric layer 432. Therefore, each FeFET RAM cell of the 3D memory array structure can be randomly accessed.

FIG. 7 illustrates a schematic circuit diagram of one exemplary memory sub-block 700 of the 3D memory array structure according to another pattern design of another exemplary 3D memory array structure. The schematic circuit diagram of the memory sub-block 700 also corresponds to one tier of 3D FeFET RAM cells in the 3D memory array structure in the X-Y plane. In one example, the memory block 405 (perspective view in FIG. 4) and the memory block 605 (top-down view in FIG. 6A) can include tiers of memory sub-block 700 stacked in the Z direction. In this example, each memory sub-block 700 can include more than two rows of FeFET RAM cells. That is, multiple rows of channel structures (e.g., channel structures 480, 680) can be arranged in each memory block. The common source line SL_1 and the common bit line BL_1 can each include more than two branch lines each extending along the X direction and located between the multiple rows of the FeFET RAM cells in an alternatingly interlaced manner. In some implementations as shown in FIG. 7, four rows of FeFET RAM cells are included in the memory sub-block 700, and share the common source line SL_1 and the common bit line BL_1. Furthermore, a number "4n" of gate lines GL_1, ..., GL_4n are each connected to a corresponding FeFET RAM cell, such that the number "4n" of FeFET RAM cells in the memory sub-block 700 can be independently controlled. Therefore, each FeFET RAM cell of the 3D memory array structure can be randomly accessed.

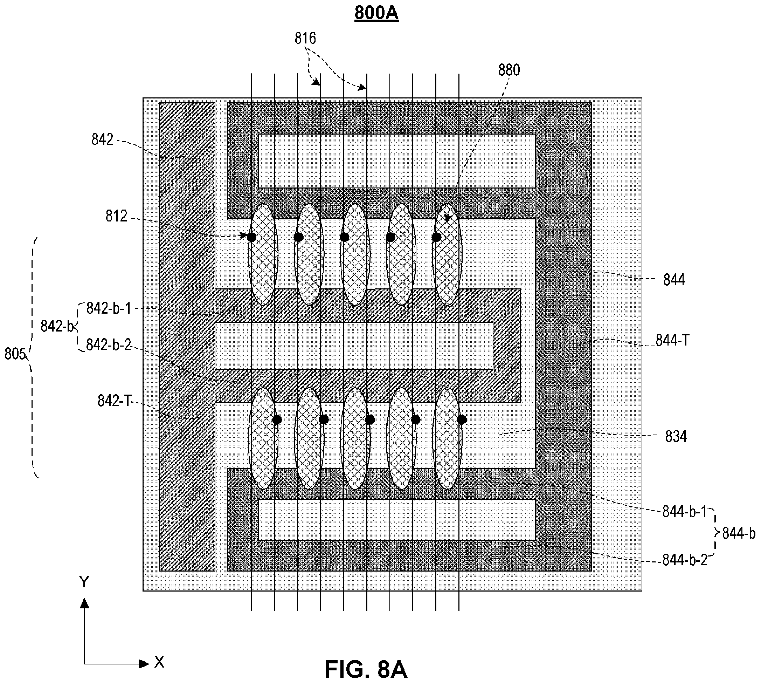

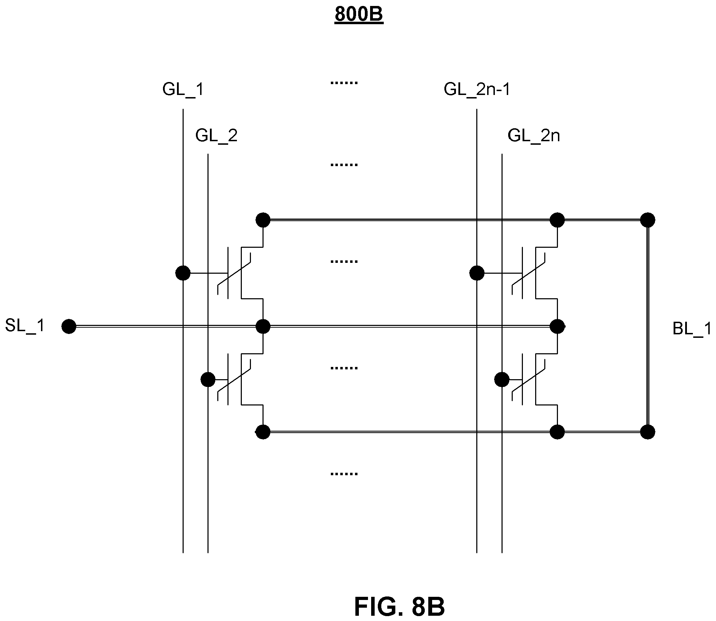

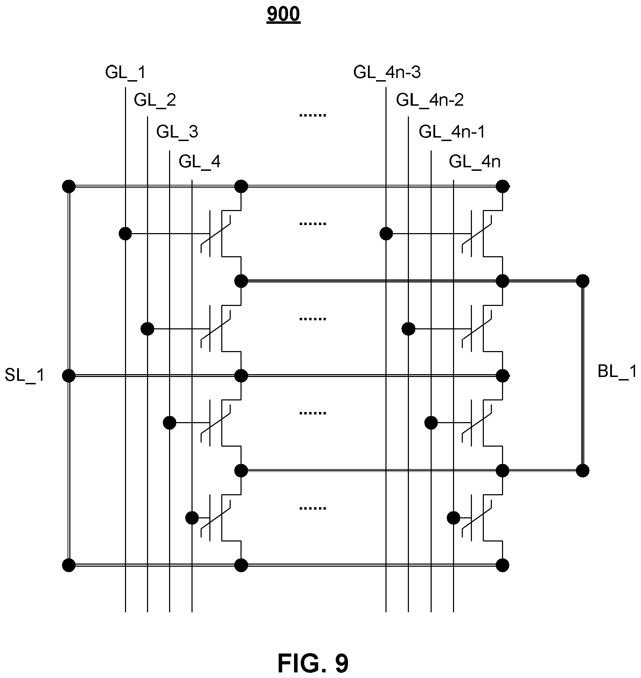

Referring to FIG. 8A, a schematic top-down view of a pattern design of another exemplary 3D memory array structure of a FeFET RAM is illustrated in accordance with some other implementations of the present disclosure. FIG. 8B illustrates a schematic circuit diagram corresponding to the pattern design of the exemplary 3D memory array structure as shown in FIG. 8A. FIG. 9 illustrates a schematic circuit diagram of another pattern design of another exemplary 3D memory array structure in accordance with some other implementations of the present disclosure. Differences between designs in FIGs. 8A-8B, 9 and FIGs. 6A-6B, 7 are described below, where similarities are omitted for simplicity.

As shown in FIG. 8A, in the X-Y plane, the 3D memory array structure 800A can include channel structures 880 arranged in an array form. The channel structures 880 can each have an oval shape in the cross section in the horizontal X-Y plane, similar to the channel structures 480, 580, 680 in FIGs. 5B, 6A. The long diameter of each channel structure 880 can be along the Y direction, and the short diameter of each channel structure 880 can be along the X direction. In the Y direction, two rows of channel structures 880 can be arranged in a memory block 805 that share a common source line 842 and a common bit line 844. In one implementation, the common source line 842 and the common bit line 844 can be formed by the conductive layer 440 in FIG. 4 and can be separated by a second dielectric layer 834 that is similar to the second dielectric layer 434 in FIG. 4. It is noted that in FIG. 8A, for illustrative purposes, five channel structures 880 are shown in each row for simplicity. In some implementations, the number "n" of the channel structures 880 in each row can be larger than five to increase storage capacity.

As shown in FIG. 8A, the common source line 842 and the common bit line 844 can each include a trunk line (also referred as "common source trunk line" 842-T and "common bit trunk line" 844-T) extending along the Y direction and located on each side of the array of the channel structures 880 respectively, and also can each include branch lines (also referred as "common source branch lines" 842-b and "common bit branch lines" 844-b) located between rows of the channel structures 880 in an alternatingly interlaced manner. In some implementations, each branch line of the common source line 842 can have a single strip shape and extend along the X direction. In some implementations, adjacent common source branch lines 842-b can be connected with each other at the distal ends that are far from the common source trunk line 842-T. Similarly, adjacent common bit branch lines 844-b can be connected with each other at the distal ends that are far from the common bit trunk line 844-T. As such, a pair of adjacent common source branch lines 842-b can form a "⊃" shape, and a pair of adjacent common bit branch lines 844-b can form a "⊂" shape. The pair of adjacent common source branch lines 842-b forming the "⊃" shape include a first portion 842-b-1 and a second portion 842-b-2. Similarly, the pair of adjacent common bit branch lines 844-b forming the "⊂" shape include a first portion 844-b-1 and a second portion 844-b-2. The common source line 842 and the common bit line 844 can each have a comb shape and can be positioned in a face-to face manner with the "⊃"-shaped or "⊂"-shaped teeth alternatingly interlaced with each other. In some implementations, the common source line 842 and the common bit line 844 can be separated by a second dielectric layer 834.

In the X-Y plane, each row of channel structures 880 are arranged between the pair of adjacent common source branch lines 842-b forming the "⊃" shape and the pair of adjacent common bit branch lines 844-b forming the "⊂" shape. In the X-Y plane along Y direction, second ends of the channel structures 880 in a first row can be commonly in contact with the first portion 842-b-1 of the pair of adjacent common source branch lines 842-b, and first ends of the channel structures 880 in a second row can be commonly in contact with the second portion 842-b-2 of the pair of adjacent common source branch lines 842-b. The first end and the second end of the channel structure 880 are on opposite sides of the channel structure 880 in the Y direction. Similarly, in the X-Y plane along Y direction, the first ends of the channel structures 880 in the first row can be commonly in contact with the second portion 844-b-2 of the pair of adj acent common bit branch lines 844-b, and the second ends of the channel structures 880 in the second row can be commonly in contact with the first portion 844-b-1 of another pair of adjacent common bit branch lines 844-b. Accordingly, two rows of the channel structures 880 in FIG. 8A sharing the common source line 842 and the common bit line 844 are symmetric along the X direction. While a same pair of adjacent common source branch lines 842-b can form the source electrodes, different pair of adjacent common bit branch lines 844-b can form the drain electrodes and can be connected to a same common bit trunk line 844-T. As such, at a same tier, the channel layers of the channel structures 880 (similar to the channel layer 530 of the channel structure 580 in FIG. 5B) in a same row can be in physical contact with the common source line 842 and the common bit line 844.

Further, as shown in FIG. 8A, the 3D memory array structure 800A can include gate lines 816 arranged parallel with each other and extending along the Y direction. Since there are two rows of channel structures 880 in each memory block, two gate lines 816 can be arranged for each column of two channel structures 880, wherein one gate line 816 can be connected to the control gate (e.g., control gate 510 as shown in FIG. 5B) of the channel structure 880 in the first row via a first control gate contact 812, and the other gate line 816 can be connected to the control gate of the channel structure 880 in the second row via a second control gate contact 814. As discussed above in connection with FIG. 5B, the oval shape of the channel structure 880 in the X-Y plane can provide an increased contacting area and/or multiple contacting area options for landing the first control gate contact 812 or the second control gate contact 814.

FIG. 8B illustrates a schematic circuit diagram of one exemplary memory sub-block 800B of the 3D memory array structure according to the pattern design as shown in FIG. 8A. It is noted that, the schematic circuit diagram of memory sub-block 800B corresponds to one tier of 3D FeFET RAM cells in the 3D memory array structure in the X-Y plane. In one example, the memory block 405 (perspective view in FIG. 4) and the memory block 805 (top-down view in FIG. 8A) can include tiers of memory sub-block 800B stacked in the Z direction. As shown in FIG. 8B, the memory sub-block 800B of the 3D memory array structure can include two rows of FeFET RAM cells. The first and second rows of FeFET RAM cells share a common source line SL_1 (similar to the common source line 842 in FIG. 8A) and a common bit line BL_1 (similar to the common bit line 844). Source electrodes of the first and second rows of FeFET RAM cells are adjacent with each other, while drain electrodes are further away from each other. A number "2n" of gate lines GL_1, ..., GL_2n can each be connected to a corresponding FeFET RAM cell, such that the number "2n" of FeFET RAM cells in the memory sub-block 800B can be independently controlled. Therefore, each memory cell of the 3D memory array structure can be randomly accessed, i.e., can be addressed individually.

FIG. 9 illustrates a schematic circuit diagram of one exemplary memory sub-block 900 of the 3D memory array structure according to another pattern design of another exemplary 3D memory array structure. In one example, the memory block 405 (perspective view in FIG. 4) and the memory block 800A (top-down view in FIG. 8A) can include tiers of memory sub-block 900 stacked in the Z direction. In some implementations, each memory sub-block can include more than two rows of FeFET RAM cells. That is, multiple rows of channel structures 880 (see FIG. 8A) can be arranged in each memory sub-block. The common source line SL_1 and the common bit line BL_1 can each include more than two branch lines each extending along the X direction and located between the multiple rows of the channel structures in an alternatingly interlaced manner. In some implementations as shown in FIG. 9, four rows of FeFET RAM cells are included in the memory sub-block 900, and share the common source line SL_1 and the common bit line BL_1. Further, a number "4n" of gate lines GL_1, ..., GL_4n are each connected to a corresponding FeFET RAM cell, such that the number "4n" of FeFET RAM cells in the memory sub-block 900 can be independently controlled. Therefore, each memory cell of the 3D memory array structure can be randomly accessed. In the exemplary arrangement of FIG. 9, adjacent rows of FeFET RAM cells share a same common source branch line or a same common bit branch line.

It is noted that the source electrodes and drain electrodes, as well as common source lines and common bit lines depend on voltages applied during application. Therefore, the aforementioned source electrodes can be used as drain electrodes, while the common source lines can be used as common drain lines, and vice versa.

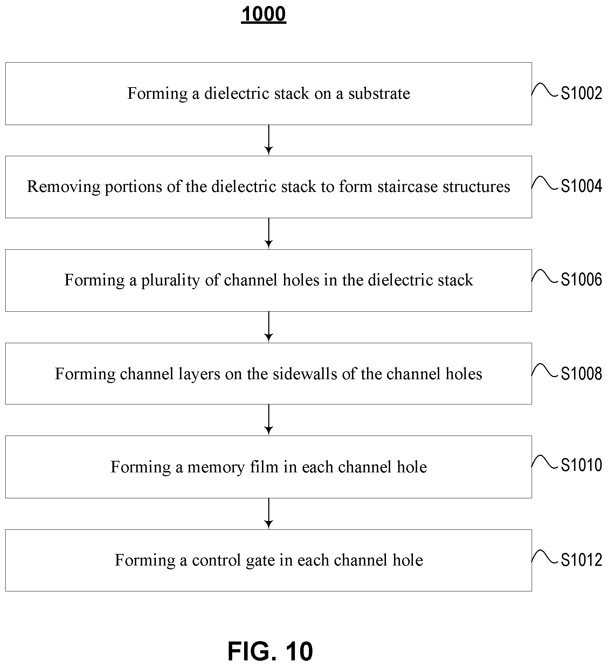

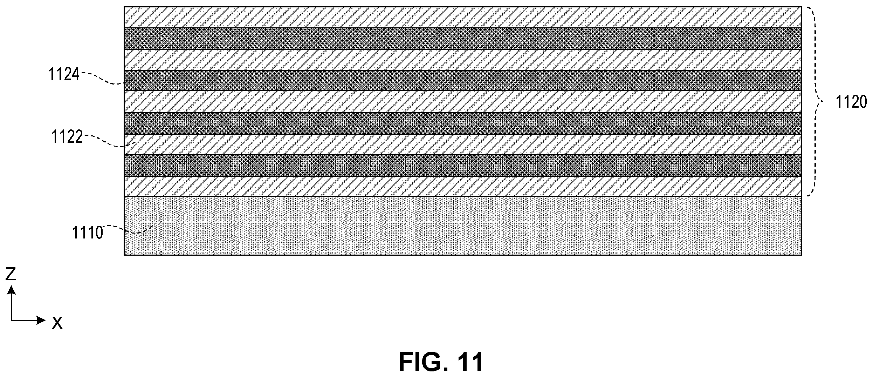

FIG. 10 illustrates a flow diagram of an exemplary method 1000 for forming a 3D memory structure, according to some implementations of the present disclosure. FIGs. 11-17B illustrate schematic cross-sectional views and/or top-down views of an exemplary 3D memory structure at certain fabricating stages of the method 1000 shown in FIG. 10 according to some implementations of the present disclosure.

As shown in FIG. 10, the method 1000 starts at operation S1002, in which a dielectric stack is formed on a substrate.

In accordance with some implementations, as shown in FIG. 11, a dielectric stack 1120 is formed on a substrate 1110 (similar to the substrate 410 in FIG. 4). The substrate 1110 can be any suitable semiconductor substrate having any suitable structure, such as a monocrystalline single-layer substrate, a polycrystalline silicon (polysilicon) single-layer substrate, a polysilicon and metal multi-layer substrate, etc. The dielectric stack 1120 including dielectric layer pairs can be formed on the substrate 1110. Each dielectric layer pairs of the dielectric stack 1120 can include an alternating stack of a first dielectric layer 1122 (similar to the first dielectric layer 432) and a second dielectric layer 1124 (similar to the second dielectric layer 434) that is different from first dielectric layer 1122. In some implementations, the first dielectric layers 1122 and portions of the second dielectric layer 1124 can be used as insulating layers, and other portions of the second dielectric layer 1124 can be used as sacrificial layers which are to be removed in the subsequent processes.

The first dielectric layers 1122 and second dielectric layers 1124 can extend in a lateral direction that is parallel to a surface of the substrate 1110. In some implementations, there are more layers than the dielectric layer pairs made of different materials and with different thicknesses in the dielectric stack 1120. The dielectric stack 1120 can be formed by one or more thin film deposition processes including, but not limited to, CVD, PVD, ALD, or any combination thereof.

In some implementations, the first dielectric layers 1122 can be oxide layers, and the second dielectric layer 1124 can be nitride layers. That is, the dielectric stack 1120 can include oxide/nitride layer pairs. It is noted that, the oxide layers 1122 and/or nitride layers 1124 can include any suitable oxide materials and/or nitride materials. In some implementations, the oxide layers can be silicon oxide layers, and the nitride layers can be silicon nitride layer. The oxide/nitride layer pairs are also referred to herein as an "oxide/nitride stack." That is, in the dielectric stack 1120, multiple oxide layers 1122 and multiple nitride layers 1124 alternate in a vertical direction. In other words, except a top and a bottom layer of a given alternating oxide/nitride stack, each of the other oxide layers 1122 can be sandwiched by two adjacent nitride layers 1124, and each of the nitride layers 1124 can be sandwiched by two adjacent oxide layers 1122.

The first dielectric layers 1122 can each have the same thickness or have different thicknesses. For example, a thickness of the first dielectric layer 1122 can be in a range from about 10 nm to about 150 nm. Similarly, the second dielectric layers 1124 can each have the same thickness or have different thicknesses. For example, a thickness of the second dielectric layer can be in a range from about 10 nm to about 150 nm. It is noted that, the thickness ranges are provided for illustration, and should not be construed to limit the scope of the appended claims.

The dielectric stack 1120 can include any suitable number of layers of the oxide layers 1122 and the nitride layers 1124. In some implementations, a total number of layers of the oxide layers 1122 and the nitride layers 1124 in the dielectric stack 1120 is equal to or larger than 60. That is, a number of oxide/nitride layer pairs can be equal to or larger than 30. In some implementations, alternating oxide/nitride stack includes more oxide layers or more nitride layers with different materials and/or thicknesses than the oxide/nitride layer pair. For example, a bottom layer and a top layer in the dielectric stack 1120 can be oxide layers 1122.

Referring to FIG. 10, the method 1000 proceeds to operation S1004, in which portions of the dielectric stack can be removed to form staircase structures.

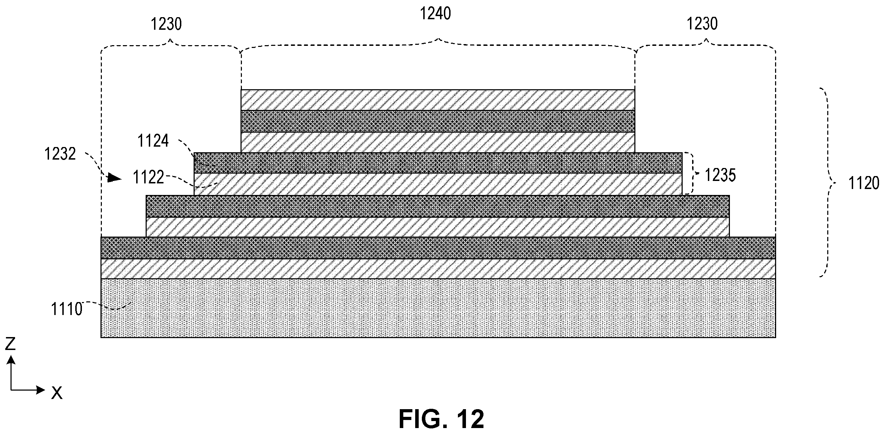

As shown in FIG. 12, portions of the dielectric stack 1120 on both sides can be removed to form two staircase structures 1232 in staircase regions 1230, the middle portion of the dielectric stack 1120 sandwiched by the two staircase structures 1232 can form an array core region 1240. In some implementations, multiple etch-trim processes can be performed repeatedly to form a set of steps. In some implementations, each step can include one or more dielectric layer pairs. As such, each step can expose a portion of the top surface of one second dielectric layer 1124. In some implementations, the etch-trim processes can include a set of repeating etch-trim processes to form the staircase structures 1232 including steps at both sides of the array core region 1240.

Specifically, for forming each step, a photoresist layer (not shown) can be used as a mask to expose a portion of the top surface of the dielectric stack 1120. For forming the first step, a width of the exposed top surface of the dielectric stack 1120 can be a step width. In some implementations, an anisotropic etching process, such as a reactive ion etching (RIE) process, or other suitable dry/wet etching process, can be performed to remove the exposed layer (e.g., the second dielectric layer 1124) that is exposed through the mask (i.e., the photoresist layer). The etching process can stop on the next lower layer (e.g.., the first dielectric layer 1122). The pattern in the mask (i.e., the photoresist layer) is then transferred to the layer (e.g., the second dielectric layer 1124) that has been etched. The exposed next lower layers (e.g., the first dielectric layers 1122) can be then removed by another etching process that stops on the next lower layers (e.g., the second dielectric layer 1124). As such, the first step can be created on the first two top layers of the dielectric stack 1120.

Next, the mask (i.e., the photoresist layer) can be reduced in size by removing a portion of the mask (also known as "trimming") above the dielectric stack 1120, such as by an isotropic etching process, to expose another step width of the dielectric stack 1120. The method can proceed by subjecting the structure to two anisotropic etching processes, including removing exposed portions of the two exposed layers (e.g., two second dielectric layers 1124), and subsequently removing exposed portions of the two exposed next lower layers (e.g., the first dielectric layers 1122). As such, the first step can be lowered to the third and fourth top layers of the dielectric stack 1120, and a second step can be created on the first two top layers of the dielectric stack 1120.

In some implementations, the successive reduction in size of the mask (i.e., the photoresist layer) and the two-step etching processes (also referred as etch-trim processes) can be repeated such that the staircase structures 1232 each including a set of steps can be formed, as shown in FIG. 12. The photoresist layer can be then removed. In some implementations, the removal process can include any suitable etching processes and cleaning processes.

Referring to FIG. 10, the method 1000 proceeds to operation S1006, in which channel holes can be formed in the dielectric stack.

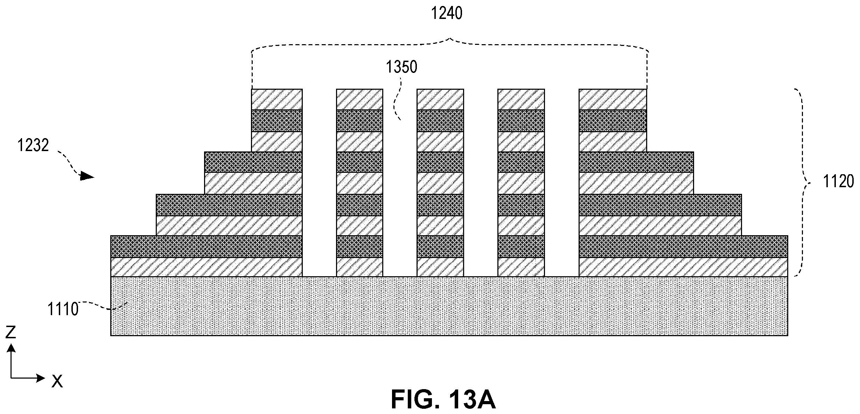

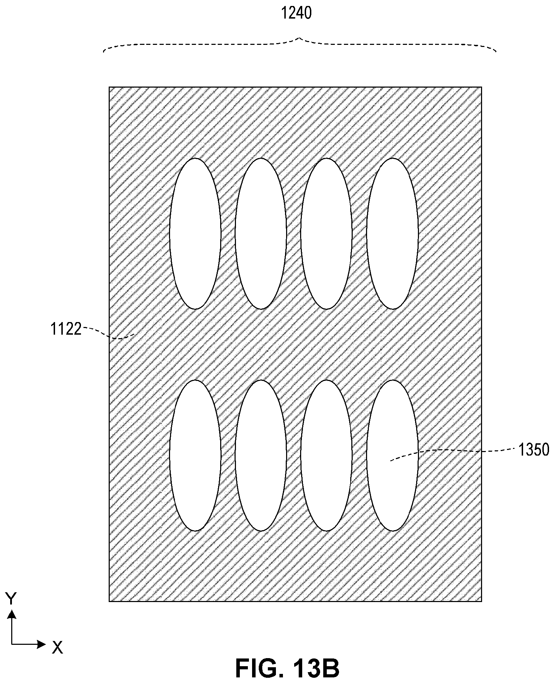

As shown in FIG. 13A, the channel holes 1350 can be located in the array core region 1240 of the dielectric stack 1120. Each channel hole 1350 can extend vertically through the dielectric stack 1120 and expose the substrate 1110. In some implementations, the channel holes 1350 can have a high aspect ratio, and can be formed by etching the dielectric stack 1120, and a subsequent cleaning process. The etching process to form the channel hole can include a wet etching, a dry etching, or a combination thereof. As shown in the top-down view of the array core region 1240 of the dielectric stack 1120 in FIG. 13B, the channel holes 1350 can be arranged as an array in the in the array core region 1240. In some implementations, the array of the channel holes 1350 can include two rows in the Y direction. In some implementations, each channel hole 1350 can have an oval in the X-Y plane. The long diameter of each channel hole 1350 can be along the Y direction, and the short diameter of each channel hole 1350 can be along the X direction.

Referring to FIG. 10, the method 1000 proceeds to operation S1008, in which channel layers can be formed on the sidewalls of the channel holes.

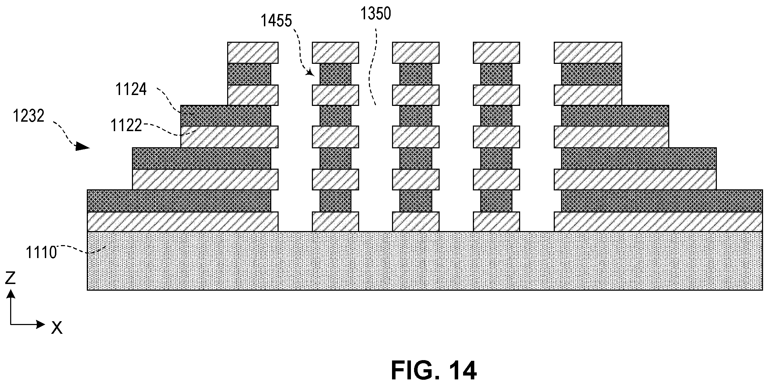

As shown in FIG. 14, the formation of the channel layers can include an etching process to remove portions of the second dielectric layers 1124 of the dielectric stack 1120 that are exposed by the plurality channel holes 1350. As such, recesses 1455 can be formed on the sidewall of each channel hole 1350.

In some implementations, portions of the second dielectric layers 1124 of the dielectric stack 1120 on the sidewall of each channel hole 1350 can be removed by used any suitable etching process, e.g., an isotropic dry etch or a wet etch. The etching process can have sufficiently high etching selectivity of the material of the second dielectric layers 1124 over the materials of the first dielectric layers 1122, such that the etching process can have minimal impact on the first dielectric layers 1122. The isotropic dry etch and/or the wet etch can remove portions of the second dielectric layers 1124 that are exposed by the multiple channel holes 1350. As such, multiple recesses 1455 can be formed on the sidewall of each channel hole 1350 laterally in the X-Y plane parallel to the substrate 1110.

In some implementations, each recess 1455 can have a horizontal hollow ring shape, with an outer sidewall as the second dielectric layer 1124 as well as a top wall and a bottom wall as the first dielectric layers 1122. That is, after the etch back process, each channel hole 1350 can have an uneven sidewall. In some implementations, the size of the etch back of the second dielectric layer 1124 can be in a range from about 5 nm to about 20 nm.

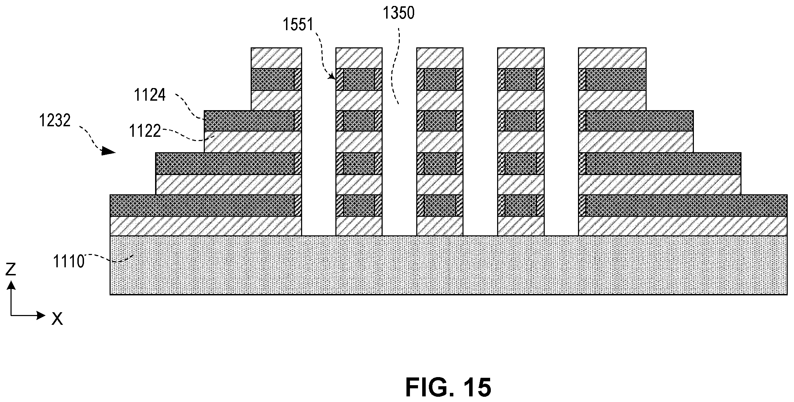

As shown in FIG. 15, the channel layers 1551 can be formed in the recesses 1455 of each channel hole 1350. In some implementations, the formation of the channel layers 1551 can include a deposition process to form a silicon layer to cover the sidewalls of the channel holes 1350. The silicon layer can be an amorphous silicon layer or a polysilicon layer formed by using a thin film deposition process, such as ALD, CVD, PVD, or any other suitable process. In some implementations, the formation of the channel layers 1551 can further include an etch process to remove portions of the silicon layer attached on the sidewall of the first dielectric layers 1122. As such, the remaining portions of the silicon layer in the recesses 1455 can formed the channel layers 1551, as shown in FIG. 15. In this example, the channel layers 1551 in each channel hole 1350 are disconnected in the vertical direction (i.e., Z direction).

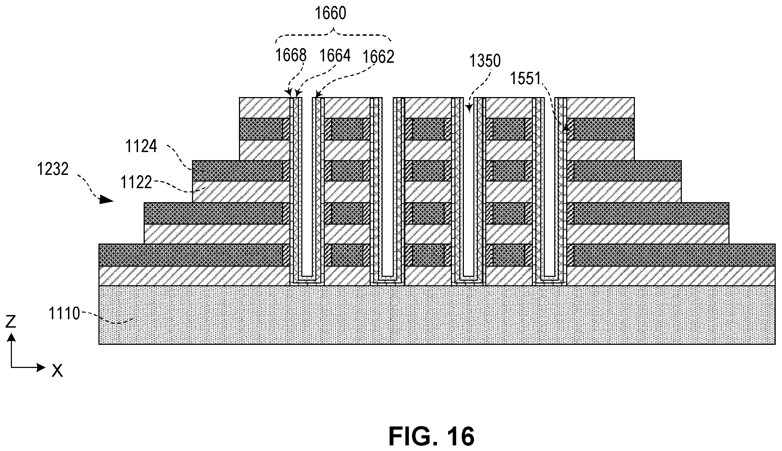

Referring to FIG. 10, the method 1000 proceeds to operation S1010, in which a memory film can be formed in each channel hole. In some implementations, as shown in FIG. 16, the memory film 1660 (similar to the memory film 220 in FIG. 2) can include a barrier layer 1662, a ferroelectric film 1664, and an interface layer 1668.

In some implementations, the interface layer 1668 (similar to the interface layer 228/558 in FIGs. 2 and 5) can be formed on the sidewall and the bottom of each channel hole 1350. The sidewall of the interface layer 1668 can be in contact with the first dielectric layers 1122 and the channel layers 1551. The bottom side of the interface layer 1668 can be in contact with the substrate 1110. The interface layer 1668 can be used to reduce the possibility of material intermixing between the ferroelectric film 1664 and the channel layers 1551. In some implementation, the interface layer 228 can be silicon oxide, silicon nitride, silicon oxynitride, high-k dielectric material (e.g., HfO₂, HfAlO, Al₂O₃), and/or any combination thereof. The interface layer 1668 can be formed by any suitable film deposition technique (e.g., ALD, CVD, sputtering, evaporation, and/or any combination thereof), or formed by oxidation, nitridation, and/or a combination thereof. A thickness of the interface layer 1668 can be in a range between about 5 nm and about 50 nm.

In some implementations, the ferroelectric film 1664 (similar to the ferroelectric film 224, 554 in FIGs. 2 and 5) can be formed to cover the interface layer 1668. The ferroelectric film 1664 can include a high-k (i.e., high dielectric constant) dielectric material, which can include transitional metal oxides such as hafnium-zirconium oxide (HZO), hafnium oxide (HfO₂), aluminum oxide (Al₂O₃), Zirconium oxide (ZrO₂), titanium oxide (TiO₂), niobium oxide (Nb₂O₅), tantalum oxide (Ta₂O₃), tungsten oxide (WO₃), molybdenum oxide (MO₃), vanadium oxide (V₂O₃), lanthanum oxide (La₂O₃), and/or any combination thereof.

In some implementations, the ferroelectric film 1664 can be disposed by chemical vapor deposition (CVD), for example, metal organic chemical vapor deposition (MOCVD), low pressure chemcial vapor deposition (LPCVD), plasma enhanced chemical vapor deposition (PECVD), high-density plasma chemical vapor deposition (HDP-CVD), etc. The ferroelectric film 1664 can also be disposed by atomic layer deposition (ALD), sputtering, evaporating, or any combination thereof. In some implementations, the ferroelectric film 1664 can have a thickness in a range between 5 nm and 100 nm.

In some implementations, to improved ferroelectric property, the high-k dielectric material of the ferroelectric film 1664 can be doped. For example, the ferroelectric film 1664 can be HZO or HfO₂ doped with silicon (Si), (Yttrium) Y, Gadolinium (Gd), Lanthanum (La), Zircomium (Zr) or Aluminum (Al), or any combination thereof. In some implementations, the ferroelectric film 224 can include Zirconate Titanate (PZT), Strontium Bismuth Tantalate (SrBi₂Ta₂O₉), Barium Titanate (BaTiO₃), PbTiO₃, and BLT ((Bi,La)4Ti₃O₁₂), or any combination thereof.

In some implementation, the barrier layer 1662 (similar to the barrier layer 222, 522 in FIGs. 2 and 5) can be formed to cover the ferroelectric film 1664. The barrier layer 1662 can be used to block the interactions between the ferroelectric film 1664 and a control gate formed in a subsequent process. The barrier layer 1662 can include titanium nitride (TiN), silicon oxide (SiO₂), silicon nitride (Si₃N₄), silicon oxynitride (Si₂O₂N), high-k dielectric materials (e.g., HfO₂, Al₂O₃), and/or any combination thereof. The barrier layer 1662 can be formed by any suitable physical vapor deposition (PVD) or chemical vapor deposition (CVD). The barrier layer 1662 can have a thickness in a range between about 5 nm and about 50 nm.

Referring to FIG. 10, the method 1000 proceeds to operation S1012, in which a control gate can be formed in each channel hole.

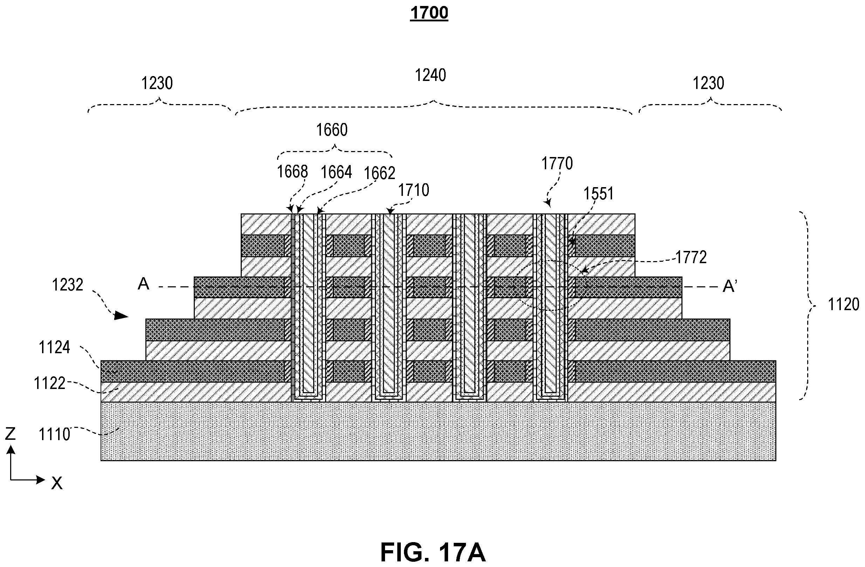

In some implementations, as shown in FIG. 17A, the 3D memory structure 1700 can be formed after completing the operation S1012, where the control gate 1710 (similar to the control gate 210, 510 in FIGs. 2 and 5) can be formed in each channel hole 1350 (FIG. 16) to cover the memory film 1660 and fill the channel hole 1350. In some implementations, the control gate 1710 can be a metal filling structure or a polycrystalline silicon filling structure formed by using any suitable deposition process, such as ALD, CVD, PVD, etc. In some implementations, a following chemical-mechanical planarization (CMP) process can be performed to remove portions of the memory film 1660 and the control gates 1710 that are outside of the channel holes 1350. In this example, an intersection between the control gate 1710, the memory film 1660 and the second dielectric layer 1124 (portions of which will be replace by a conductive layer in the subsequent process) can form a memory cell 1772, where a channel structure 1770 includes memory cells 1772 stacked in the Z direction. The channel structure 1770 (similar to the channel structures 480, 580, 680, 880 in FIGs. 4, 5A-5B, 6A, 8A) vertically extends through the dielectric stack 1120. The channel structure 1770 is similar to the channel structures 480/580/680/880 described previously with respect to FIGs. 4, 5A-5B, 6A, 8A.

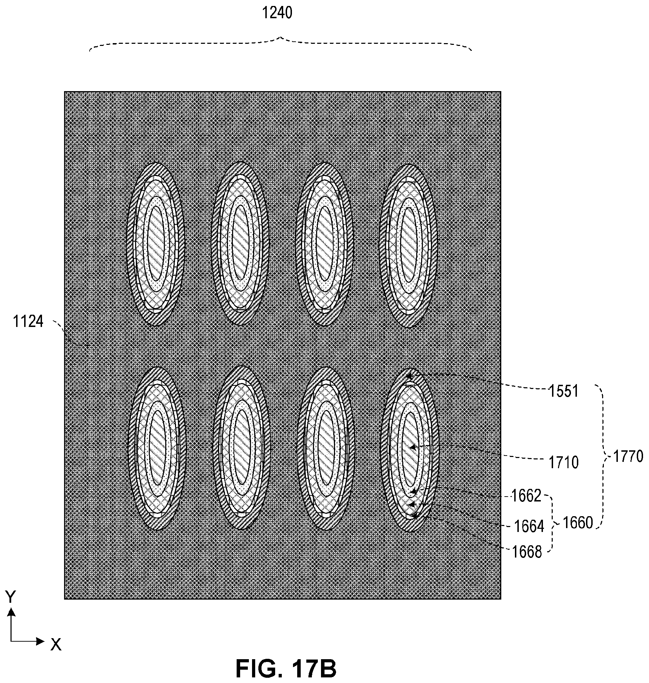

FIG. 17B illustrates a horizontal cross-sectional view of the 3D memory structure of FIG. 17A along the AA' line. As shown in FIG. 17B, channel structures 1770 are arranged in an array in the X-Y plane in the array core region 1240, and are separated by the second dielectric layers 1124. In some implementations, the array of channel structures 1770 can include two rows in the Y direction. In some implementations, each channel structure 1770 can include the channel layer 1551, the memory film 1660, and the control gate 1710. In the X-Y plane, the channel layer 1551 (similar to the channel layer 230, 530 in FIGs. 2 and 5) can encircle the memory film 1660, and the memory film 1660 can encircle the control gate 1710. In some implementations, the memory film 1660 can include the barrier layer 1662, the ferroelectric film 1664, and the interface layer 1668. In the X-Y plane, the interface layer 1668 can encircle the ferroelectric film 1664, and the ferroelectric film 1664 can encircle the barrier layer 1662. In some implementations, each channel structure 1770 can have an oval shape in the X-Y plane. The long diameter of each channel structure 1770 can be along the Y direction, and the short diameter of each channel structure 1770 can be along the X direction.

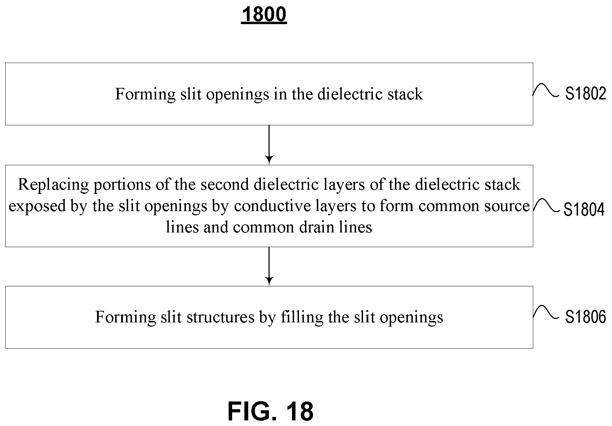

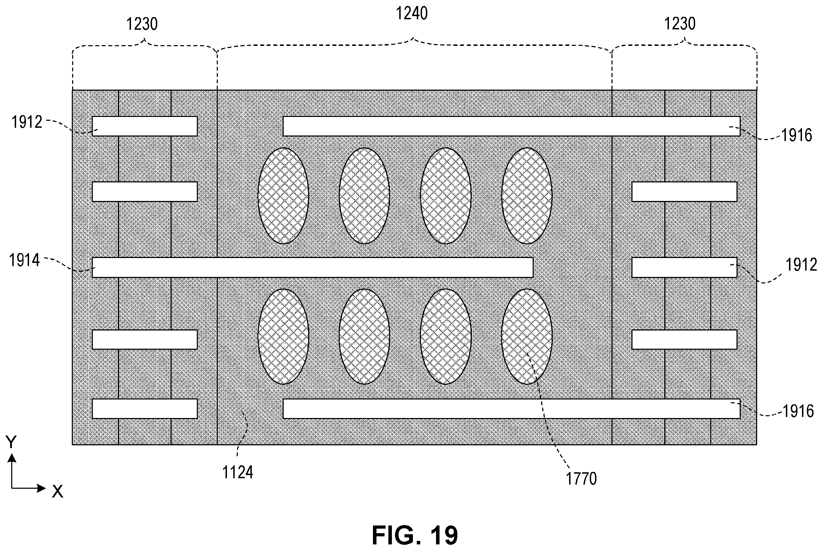

FIG. 18 illustrates a flow diagram of an exemplary method 1800 for forming exemplary source and drain connections of a 3D memory structure, according to some implementations of the present disclosure. FIGs. 19-21 illustrate schematic cross-sectional views and/or top-down views of an exemplary 3D memory structure at certain fabricating stages of the method 1800 shown in FIG. 18 according to some implementations of the present disclosure.

Referring to FIG. 18, the method 1800 can start at operation S1802, in which slit openings can be formed in the dielectric stack.

FIG. 19 illustrates a horizontal cross-sectional view (in an X-Y plane) of a 3D memory structure along the AA' line (FIG. 17A), according to the operation S1802. As shown in FIG. 19, slit openings 1912, 1914, and 1916 penetrate the dielectric stack 1120 in the vertical direction (e.g., Z direction) exposing the substrate 1110, and extend substantially in a straight line along the X direction and in parallel in the Y direction. In some implementations, the slit openings 1912, 1914, and 1916 can be formed by forming a mask layer (not shown) over the dielectric stack 1120 (see FIG. 17A) in the staircase regions 1230 and the array core region 1240, and patterning the mask layer using, e.g., photolithography, to form openings corresponding to the slit openings in the patterned mask layer. A suitable etching process, e.g., dry etch and/or wet etch, can be performed to remove portions of dielectric stack 1120 exposed by the openings until the slit openings 1912, 1914, and 1916 expose the substrate 1110. The mask layer can be removed after the formation of the slit openings 1912, 1914, and 1916.

The formed plurality of slit openings can include short slit openings 1912 that are located in the two staircase regions 1230 on both sides of the array core region 1240, and can further include long slit openings 1914 and 1916 that are located in both staircase region 1230 and the array core region 1240. In some implementations as shown in FIG. 19, one or more left long slit openings 1914 can be located in the left staircase region 1230 and in a left portion of the array core region 1240, and one or more right long slit openings 1916 can be located in the right staircase region 1230 and in a right portion of the array core region 1240. The one or more left long slit openings 1914 and one or more right long slit openings 1916 can be arranged alternatingly along the Y direction, and can be separated by a row of channel structures 1770. In one example as shown in FIG. 19, one or more left long slit opening 1914 can be located between the two rows of the channel structures 1770, and two right long slit openings 1916 can be located above and below the two rows of the channel structures 1770 respectively.

Referring to FIG. 18, the method 1800 can process to operation S1804, in which portions of the second dielectric layers of the dielectric stack exposed by the slit openings can be replaced by conductive layers to form common source lines and common bit lines.

In some implementations, operation S1804 can include removing, laterally in the X-Y plane, portions of the second dielectric layers 1124 of the dielectric stack 1120 exposed by the slit openings 1912, 1914, and 1916 to form multiple horizontal trenches. In some implementations, the portions of the second dielectric layers 1124 in the dielectric stack 1120 can be removed by using any suitable recess etching process, e.g., an isotropic dry etch or a wet etch. The etching process can have sufficiently high etching selectivity of the material of the second dielectric layers 1124 over the materials of the first dielectric layers 1122 of the dielectric stack 1120 and the channel layers 1551 of the channel structures 1770, such that the etching process can have minimal impact on the first dielectric layers 1122 and the channel layers 1551. In some implementations, the second dielectric layers 1124 include silicon nitride and the etchant of the isotropic dry etch includes one or more of CF₄, CHF₃, C4F₈, C4F₆, and CH₂F₂. The radio frequency (RF) power of the isotropic dry etch can be lower than about 100W and the bias can be lower than about 10V. In some implementations, the second dielectric layers 1124 include silicon nitride and the etchant of the wet etch includes phosphoric acid.

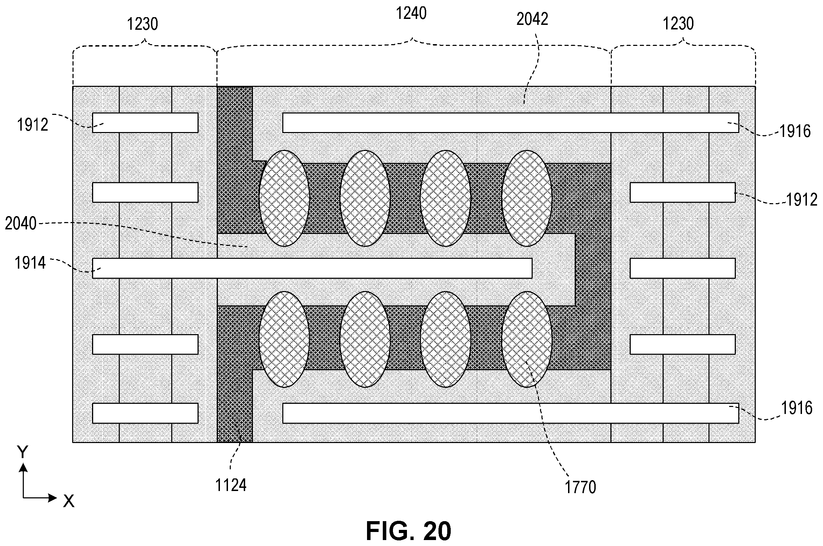

In some implementations, the recess etching process can remove portions of second dielectric layers 1124 in various directions through the slit openings 1912, 1914, and 1916. As such, multiple horizontal trenches can then be formed to extend in a horizontal direction into a certain depth recessing from the sidewalls of the slit openings 1912, 1914, and 1916. In some implementations, the horizontal trenches in the staircase regions 1230 can be interconnected with each other. That is, the second dielectric layers 1124 in the staircase regions 1230 can be completely removed to form multiple horizontal trenches. In the array core region 1240, due to the distance between adjacent long slit openings 1914 and 1916, portions of the second dielectric layers 1124 can be remained, as shown in FIG. 20.

After portions of the second dielectric layers 1124 are removed, the multiple slit openings 1912, 1914, and 1916 and multiple horizontal trenches can be cleaned by using any suitable cleaning process. For example, a phosphoric acid rinsing process can be performed to remove the impurities on the inner wall of the horizontal trenches..
After the cleaning process, In some implementations, conductive layers 2040, 2042 (similar to conductive layers 440 in FIG. 4) can be formed in the multiple horizontal trenches. The conductive layers 2040, 2042 can be formed by filling the multiple horizontal trenches with any suitable conductive material, e.g., tungsten, aluminum, copper, cobalt, or any combination thereof. The conductive material can be deposited into horizontal trenches using a suitable deposition method such as CVD, PVD, plasma-enhanced CVD (PECVD), sputtering, metal-organic chemical vapor deposition (MOCVD), and/or ALD.

In some implementations as shown in FIG. 20, in the X-Y plane of each tier corresponding to one step of the staircase, the conductive layer can include a left portion of the conductive layer 2040 formed around the one or more left long slit openings 1914, and a right portion of the conductive layer 2042 formed around one or more right long slit openings 1916. The left portion of the conductive layer 2040 and the right portion of the conductive layer 2042 are separated by the un-etched portion of the second dielectric layers 1124. The left portion of the conductive layer 2040 is in contact with the channel layer 1551 (see FIG. 17B) of each channel structure 1770 at one end of the long diameter of each channel structure 1770, such as the second ends of the first row of channel structures and the first ends of the second row of channel structures. The right portion of the conductive layer 2042 is in contact with the channel layer 1551 of each channel structure 1770 at the other end of the long diameter of each channel structure 1770, such as the first ends of the first row of channel structures and the second ends of the second row of channel structures. Therefore, the left portion of the conductive layer 2040 and the right portion of the conductive layer 2042 can be used as a common source line (e.g., the common source lines 642, 842 in FIGs. 6A, 8A) and a common bit line (e.g., the common bit lines 644, 844) respectively.

Referring to FIG. 18, the method 1800 can process to operation S1806, in which slit structures can be formed by filling the slit openings with a filling material.

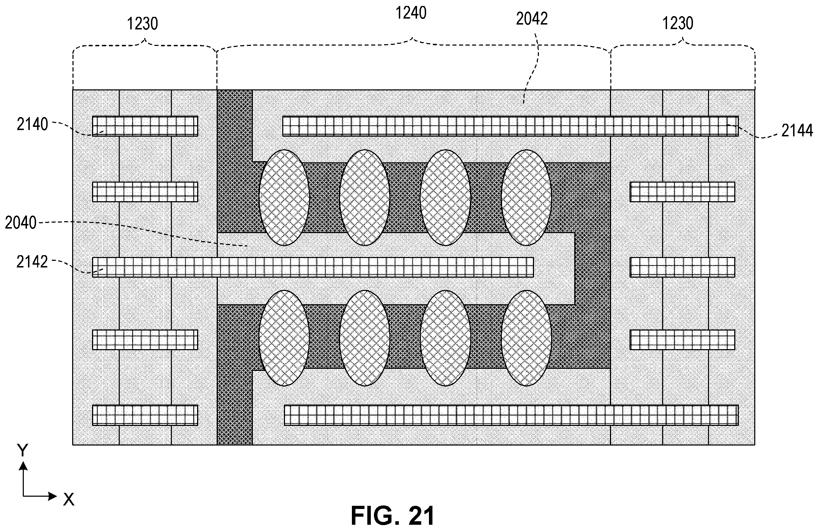

As shown in FIG. 21, slit structures 2140, 2142, 2144 can be formed by filling each of the multiple slit openings 1912, 1914, and 1916 with a filling material. In some implementations, the filling material of the slit structures 2140, 2142, 2144 can be disposed by using any suitable deposition process, such as CVD, PVD, ALD, etc., processes to deposit a low temperature oxide or nitride material or a high temperature oxide or nitride material to fill the multiple slit openings 1912, 1914, and 1916.

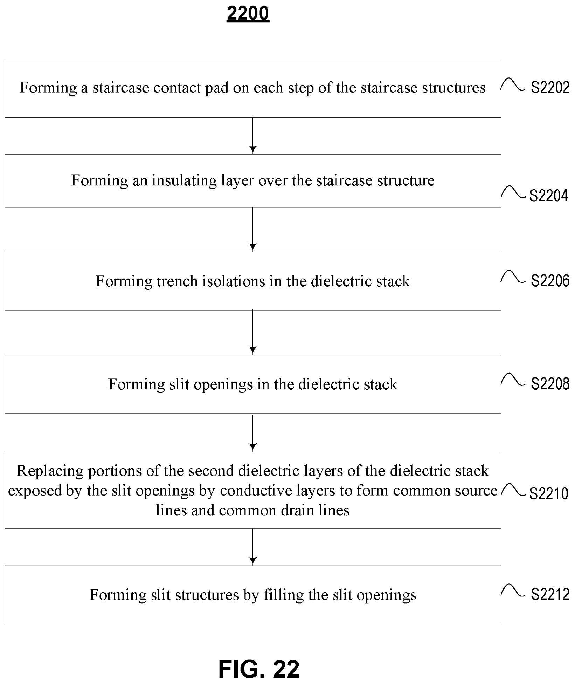

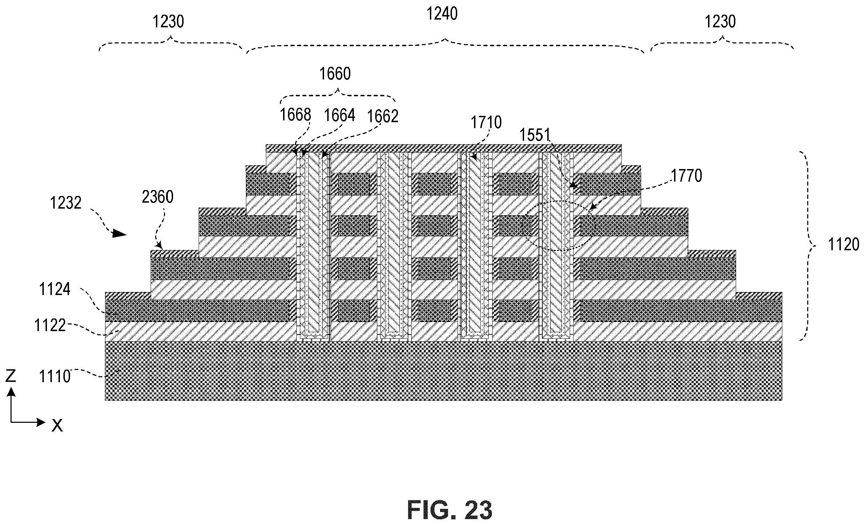

FIG. 22 illustrates another flow diagram of another exemplary method for forming exemplary source and drain connections of a 3D memory structure, according to some implementations of the present disclosure. FIGs. 23-27 and 28A-28C illustrate schematic cross-sectional views and top-down views an exemplary 3D memory structure at certain fabricating stages of the method 2200 shown in FIG. 22 according to some implementations of the present disclosure.

Referring to FIG. 22, the method 2200 can start at operation S2202, in which a staircase contact pad can be formed on each step of the staircase structures after completing the operation S1012 of the method 1000 shown in FIG. 10.

As shown in FIG. 23, the staircase contact pad 2360 can be disposed on the 3D memory structure 1700 (in FIG. 17A) according to the operation S2202. The staircase contact pad 2360 can cover the exposed portion of the second dielectric layer 1124 of each step of the staircase structure 1232. In some implementations, a portion of the staircase contact pad 2360 covering a vertical sidewall of each step of the staircase structures 1232 (e.g., covering a sidewall of the first dielectric layer 1122 and a sidewall of the second dielectric layer 1124) can be removed by using, for example, wet etch or dry etch. As such, the staircase contact pad 2360 on each step of the staircase structures 1232 are disconnected from adjacent staircase contact pads on an upper step or a lower step. In some implementations, the staircase contact pad 2360 on each step of the staircase structures 1232 can extend laterally, e.g., along the Y direction.

In some implementations, the staircase contact pad 2360 can be thinner than the first dielectric layer 1122 and/or the second dielectric layer 1124 , and can include polycrystalline, amorphous or microcrystalline semiconductor material such as silicon, germanium, silicon germanium, or a combination thereof. The staircase contact pad 2360 can be disposed over the 3D memory structure 1700 by using a suitable thin film deposition technique such as CVD, PVD, ALD, sputtering, evaporation, etc. In some implementations, to improve conductivity, the staircase contact pad 2360 can be doped with n-type or p-type dopants, for example, boron, phosphine, arsenic, etc.

Referring to FIG. 22, the method 2200 can process to operation S2204, in which an insulating layer can be formed over the staircase structures.

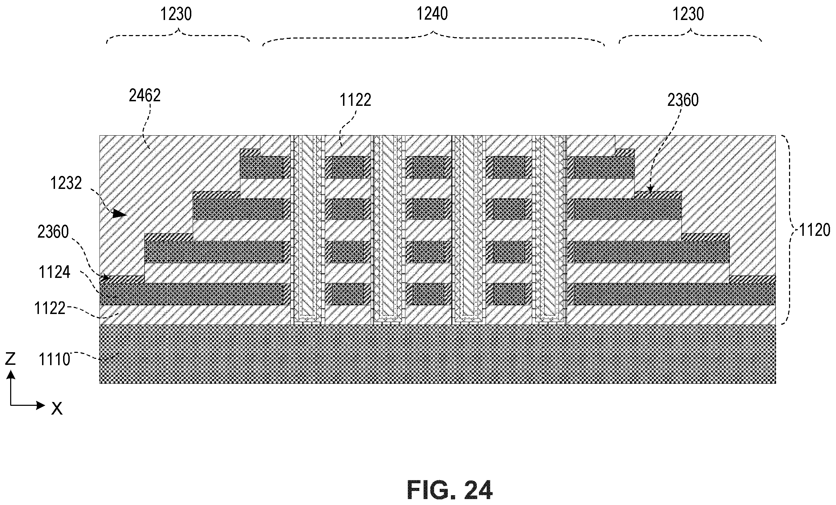

As shown in FIG. 24, the insulating layer 2462 can be formed over the staircase structures 1232 according to the operation S2204. The insulating layer 2462 can include any suitable insulating material, for example, silicon oxide, silicon nitride, silicon oxynitride, low-k dielectrics. In some implementations, the insulating layer 2462 can be disposed over the staircase structures by using a suitable film deposition technique, for example, CVD, PVD, ALD, sputtering, evaporation, or a combination thereof. In some implementations, a planarization process (e.g., chemical mechanical polishing) can be implemented to form a planar top surface. In some implementations, the staircase contact pad 2360 disposed on the dielectric stack 1120 in the array core region 1240 can be removed. In some implementations, the first dielectric layer 1122 can be exposed on top of the dielectric stack 1120 in the array core region 1240.

Referring to FIG. 22, the method 2200 can process to operation S2206, in which trench isolations can be formed in the dielectric stack in the array core region.

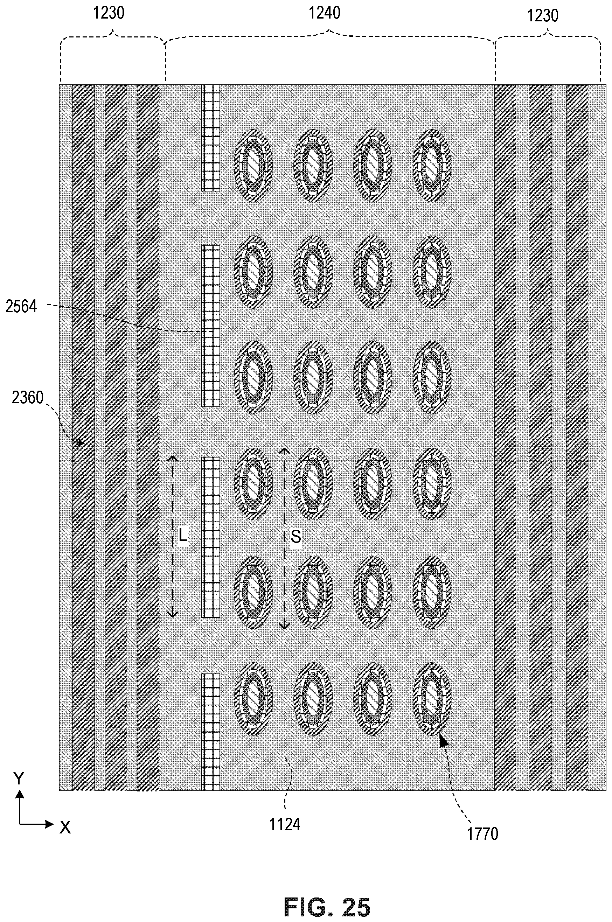

FIG. 25 illustrates a top-down view of a 3D memory structure, according to the operation S2206. The insulating layer 2462 and the first dielectric layer 1122 are omitted in FIG. 25 for simplicity. As shown in FIG. 25, trench isolations 2564 can be formed to penetrate the dielectric stack 1120 in the vertical direction (e.g., Z direction) in the core array region 1240. In some implementations, the trench isolations 2564 extend into the substrate 1110 (in FIG. 24). The trench isolations 2564 can be formed using similar techniques as the slit structures 2140 in FIG. 21. For example, trench isolation openings can be formed first by disposing a mask layer (not shown) over the dielectric stack 1120 (see FIG. 24) in the array core region 1240, and patterning the mask layer using, e.g., photolithography, to form openings corresponding to the trench isolations in the patterned mask layer. A suitable etching process, e.g., dry etch and/or wet etch, can be performed to remove portions of dielectric stack 1120 exposed by the openings until the trench isolation openings expose the substrate 1110. The mask layer can be removed after the formation of the trench isolation openings. Subsequently, the trench isolation openings can be filled with a filling material to form the trench isolations 2564. In some implementations, the filling material of the trench isolations 2564 can be disposed by using any suitable deposition process, such as CVD, PVD, ALD, etc. The filling material for the trench isolations 2564 can include any suitable insulating material that is different from the second dielectric layers 1124. In some implementations, the filling material for the trench isolations 2564 can be silicon oxide when the second dielectric layers 1124 include silicon nitride.

As shown in FIG. 25, the channel structures 1770 can be arranged in an array in the X-Y plane in the array core region 1240, and can be separated by the second dielectric layers 1124. In the example of FIG. 25, the array of channel structures 1770 can include six rows in the Y direction, each row including four channel structures 1770 in the X direction. Each channel structure 1770 is similar to the ones shown in FIG. 17B, and can include the channel layer 1551, the memory film 1660, and the control gate 1710. In the X-Y plane, the channel layer 1551 can encircle the memory film 1660, and the memory film 1660 can encircle the control gate 1710. In some implementations, the memory film 1660 can include the barrier layer 1662, the ferroelectric film 1664, and the interface layer 1668. In the X-Y plane, the interface layer 1668 can encircle the ferroelectric film 1664, and the ferroelectric film 1664 can encircle the barrier layer 1662. In some implementations, each channel structure 1770 can have an oval shape in the X-Y plane. The long diameter of each channel structure 1770 can be along the Y direction, and the short diameter of each channel structure 1770 can be along the X direction.

In some implementations, the trench isolations 2564 extend substantially in a straight line along the Y direction, and are disconnected in the Y direction. The disconnected trench isolations 2564 do not overlap with each other. In the X direction, each trench isolation 2564 aligns substantially with two rows of the channel structures 1770. In the Y direction in the X-Y plane, a first end of each trench isolation 2564 aligns with first portions of a first row of channel structures 1770, and a second end of each trench isolation 2564 aligns with second portions of a second row of channel structures 1770. In the Y direction, each trench isolation 2564 has a length "L" slightly less than a distance "S" from top of the first row of channel structures to bottom of the second row of the channel structures. Namely, a spacing between the rows plus twice of the long diameter of the channel structure 1770 is slightly larger than the length "L" of the trench isolation 2564 in Y direction. The difference between the distance "S" and the length "L" can determine contact areas between the channel structures 1770 and the common source line and the common bit line formed in the subsequent processes.

Referring to FIG. 22, the method 2200 can process to operation S2208, in which slit openings can be formed in the dielectric stack.

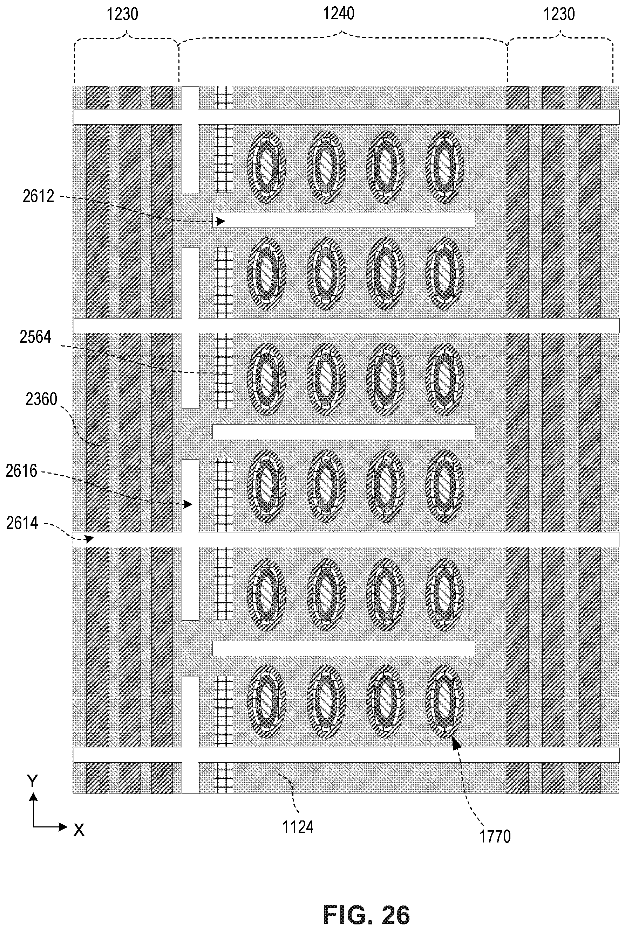

As shown in FIG. 26, slit openings, including a first set of slit openings 2612, a second set of slit openings 2614 and a third set of slit openings 2616, can be formed in the dielectric stack 1120 (FIG. 24) according to the operation S2208. In the vertical direction (e.g., Z direction), the slit openings 2612/2614/2616 penetrate the dielectric stack 1120. In some implementations, the slit openings 2612/2614/2616 expose the substrate 1110. The first set of slit openings 2612 can be disposed in the array core region 1240, extending laterally in the X direction. The second set of slit openings 2614 can be disposed in both staircase regions 1230 and the array core region 1240. The second set of slit openings 2614 extend laterally across the left staircase region 1230, the array core region 1240 and the right staircase region 1230 and can be substantially in a straight line along the X direction. In some implementations, the first set of slit openings 2612 and the second set of slit openings 2614 can be arranged alternatingly along the Y direction, and can be separated by a row of channel structures 1770. In the example shown in FIG. 26, the first set of slit openings 2612 can be disposed between two rows of channel structures 1770, and the second set of slit openings 2614 can be disposed above and below the two rows of channel structures 1770 respectively.

In some implementations, the third set of slit openings 2616 extend laterally in the Y direction, parallel to the trench isolations 2564 and perpendicular to the first set of slit openings 2612 and the second set of slit openings 2614. In some implementations, the third set of slit openings 2616 can be disposed in the array core region 1240 between the left staircase region 1230 and the trench isolations 2564. In some implementations, the third set of slit openings 2616 have similar length as the trench isolations 2564 in the Y direction, and are substantially aligned with the trench isolations 2564.

In some implementations, the second set of slit openings 2614 intersect with the third set of slit openings 2616 and the trench isolations 2564 in the array core region 1240. In some implementations, the second set of slit openings 2614 intersect with the staircase contact pads 2360 in the staircase region 1230. In some implementations, the first set of slit openings 2612 is distant from, and do not intersect with, the third set of slit openings 2616 and the trench isolations 2564.

In some implementations, the slit openings 2612/2614/2616 can be formed similarly as the slit structures 2140 in FIG. 21. For example, slit openings can be formed first by disposing a mask layer (not shown) over the dielectric stack 1120 (see FIG. 24) in the array core region 1240, and patterning the mask layer using, e.g., photolithography, to form openings corresponding to the slit openings in the patterned mask layer. A suitable etching process, e.g., dry etch and/or wet etch, can be performed to remove portions of dielectric stack 1120 exposed by the openings until the slit openings 2612/2614/2616 expose the substrate 1110. The mask layer can be removed after the formation of the slit openings.

Referring to FIG. 22, the method 2200 can process to operation S2210, in which portions of the second dielectric layers of the dielectric stack exposed by the slit openings can be replaced by conductive layers to form common source lines and common bit lines.

In some implementations, operation S2210 can include removing, laterally in the X-Y plane, portions of the second dielectric layers 1124 of the dielectric stack 1120 exposed by the slit openings (including the first set of slit openings 2612, the second set of slit openings 2614, and the third set of slit openings 2616) to form multiple horizontal trenches. In some implementations, the portions of the second dielectric layers 1124 in the dielectric stack 1120 can be removed by using any suitable recess etching process, e.g., an isotropic dry etch or a wet etch. The etching process can have sufficiently high etching selectivity of the material of the second dielectric layers 1124 over the materials of the first dielectric layers 1122 of the dielectric stack 1120, the channel layers 1551 of the channel structures 1770, the trench isolations 2564, and the staircase contact pads 2360, such that the recess etching process of the second dielectric layers 1124 can have minimal impact on the first dielectric layers 1122, the channel layers 1551, trench isolations 2564 and the staircase contact pads 2360. In some implementations, the second dielectric layers 1124 include silicon nitride and the etchant of the isotropic dry etch includes one or more of CF₄, CHF₃, C4F₈, C4F₆, and CH₂F₂. The radio frequency (RF) power of the isotropic dry etch can be lower than about 100W and the bias can be lower than about 10V. In some implementations, the second dielectric layers 1124 include silicon nitride and the etchant of the wet etch includes phosphoric acid.

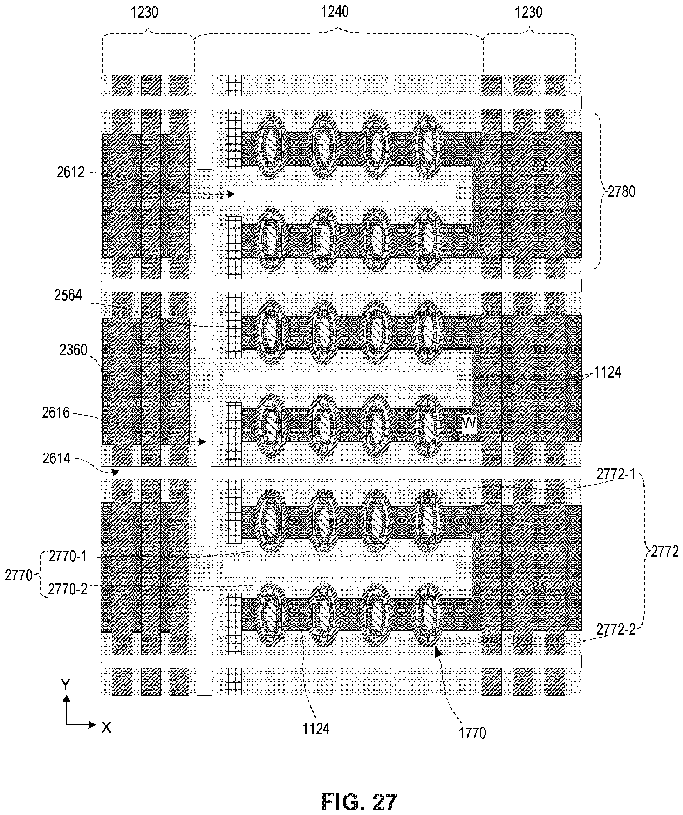

In some implementations, the recess etching process can remove portions of second dielectric layers 1124 in various directions (e.g., in both X and Y directions) through the slit openings 2612, 2614 and 2616. As such, multiple horizontal trenches can then be formed to extend in a horizontal direction into a certain depth recessing from the sidewalls of the slit openings 2612, 2614, and 2616. The horizontal recess of the second dielectric layers 1124 along X and Y directions can be controlled by etching rate and/or etching time during the recess etching process. In some implementations, due to the distance from adjacent slit openings 2612, 2614 and 2616, portions of the second dielectric layers 1124 can be remained, as shown in FIG. 27. For example, a stripe of second dielectric layers 1124 in X direction can be preserved for each row of channel structures 1770 after the recess etching process. The stripe of second dielectric layers 1124 can have a width "W" along Y direction.

In some implementations, the trench isolations 2564 can be selective to the recess etching process for the second dielectric layers 1124. As such, each trench isolation 2564 can function as an etch-stop such that horizontal trenches around the trench isolations 2564 will not be merged, for example, in X direction across the trench isolations 2564.

After portions of the second dielectric layers 1124 are removed, the slit openings 2612, 2614, and 2616 and the multiple horizontal trenches can be cleaned by using any suitable cleaning process. For example, a phosphoric acid rinsing process can be performed to remove the impurities on the inner wall of the horizontal trenches.

After the cleaning process, in some implementations, conductive layers 2770, 2772 (similar to conductive layers 440 in FIG. 4) can be formed in the multiple horizontal trenches. The conductive layers 2770, 2772 can be formed by filling the multiple horizontal trenches with any suitable conductive material, e.g., tungsten, aluminum, copper, cobalt, or any combination thereof. The conductive material can be deposited into horizontal trenches using a suitable deposition method such as CVD, PVD, plasma-enhanced CVD (PECVD), sputtering, metal-organic chemical vapor deposition (MOCVD), and/or ALD.

In some implementations as shown in FIG. 27, in the X-Y plane of each tier corresponding to one step of the staircase, the conductive layer can include a left portion of the conductive layer 2770 formed around the first set of slit openings 2612, and a right portion of the conductive layer 2772 formed around the second set of slit openings 2614. The left portion of the conductive layer 2770 and the right portion of the conductive layer 2772 can be separated, in the X direction, by the trench isolations 2564, and can be separated, in the Y direction, by the un-etched portion of the second dielectric layers 1124, for example, by the stripe of the second dielectric layers 1124 having the width "W". In one implementation, the trench isolations 2564 is connected with the second dielectric layers 1124. In some implementations, the left portion of the conductive layer 2770 can be in contact with the channel layer 1551 (see FIG. 17B) of each channel structure 1770 at one end of the long diameter of each channel structure 1770. For example, conductive layer 2770-1 can contact second ends of a first row of channel structures and conductive layer 2770-2 can contact first ends of a second row of channel structures. The left portion of the conductive layer 2770 can also contact the staircase contact pad 2360 in a left staircase region 1230. The right portion of the conductive layer 2772 can contact the channel layer 1551 of each channel structure 1770 at the other end of the long diameter of each channel structure 1770. For example, conductive layer 2772-1 can contact first ends of the first row of channel structures and conductive layer 2772-2 can contact second ends of the second row of channel structures. The right portion of the conductive layer 2772 can also contact the staircase contact pad 2360 in a right staircase region 1230. In some implementations, the conductive layers 2770-1 and 2770-2 can be connected physically in the array core region 1240. While the conductive layers 2772-1 and 2772-2 are physically separated by the second dielectric layers 1124 in the array core region 1240, the conductive layers 2772-1 and 2772-2 can be electrically connected through the staircase contact pad 2360 in the right staircase region 1230. Therefore, the left portion of the conductive layer 2770 and the right portion of the conductive layer 2772 can be used as a common source line and a common bit line respectively and can be connected through staircase structures in the left and right staircase regions 1230 respectively.

In some implementations, the trench isolations together with the un-etched (remaining) portions of the second dielectric layers 1124 can provide electrical isolations between the left portion of the conductive layer 2770 and the right portion of the conductive layer 2772 and thereby provide electrical isolation between common source line and common bit line. The second set of slit openings 2614, which extend across both staircase regions 1230 and the array core region 1240, can also separate rows of the channel structures 1770 into different memory blocks. In FIG. 27, adjacent slit openings 2614 can define a memory block 2780 having two rows of channel structures 1770.

In the staircase region, the conductive layer 2772 can also be formed in each staircase step by replacing a portion of the second dielectric layer 1124. As such, the staircase contact pad 2360 can contact a portion of the conductive layer 2772 from above. In some implementations, the staircase contact pad 2360 can also contact a portion of residual second dielectric layer 1124 from above.

Referring to FIG. 22, the method 2200 can process to operation S2212, in which slit structures can be formed by filling the slit openings with a filling material.

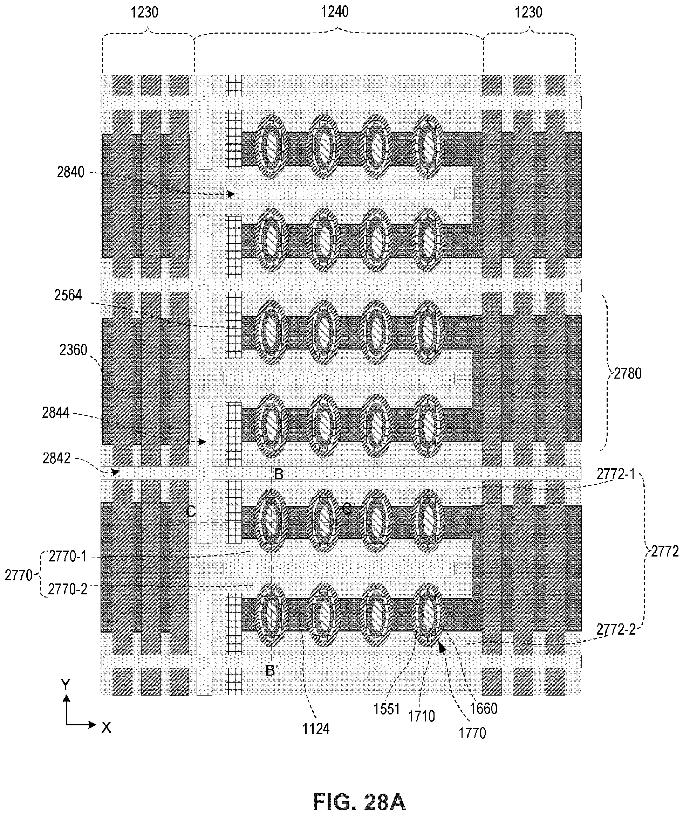

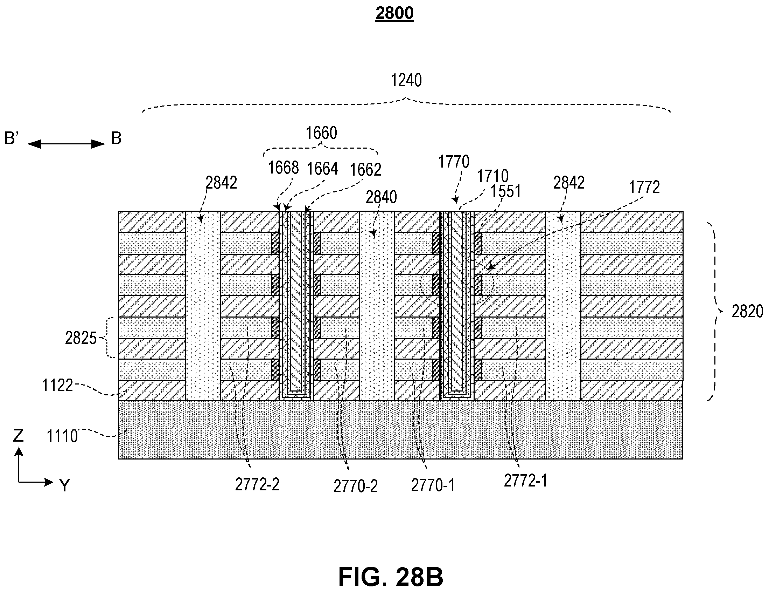

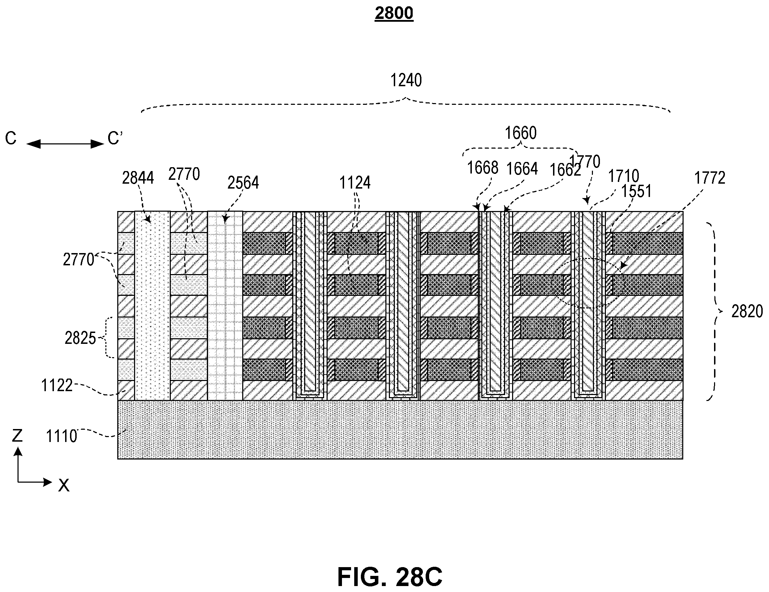

FIG. 28A illustrates a top-down view of a 3D ferroelectric memory device 2800 according to the operation S2212. FIG. 28B illustrates a cross-sectional view of the 3D ferroelectric memory device 2800 along line BB' in FIG. 28A. FIG. 28C illustrates a cross-sectional view of the 3D ferroelectric memory device 2800 along line CC' in FIG. 28A. As shown in FIG. 28A, slit structures (including a first set of slit structures 2840, a second set of slit structures 2842 and a third set of slit structures 2844) can be formed by filling each of the slit openings (including the first set of slit openings 2612, the second set of slit openings 2614, and the third set of slit openings 2616) with a filling material. In some implementations, the filling material of the slit structures 2840, 2842 and 2844 can be disposed by using any suitable deposition process, such as CVD, PVD, ALD, etc. The filling material can include any suitable insulating material, for example, silicon oxide, silicon nitride, silicon oxynitride or a combination thereof.

As shown in FIG. 28A, the ferroelectric memory device 2800 includes memory blocks 2780. Each memory block 2780 can be isolated from adjacent memory blocks by the second set of slit structures 2842 extending laterally across both the staircase regions 1230 and the array core region 1240 in the X direction. In this example, each memory block 2780 includes two rows of channel structures 1770 and each row includes four channel structures 1770.

After replacing portions of the second dielectric layer 1124 with conductive layers 2770, 2772, the dielectric stack 1120 (in FIG. 24) becomes a film stack 2820, as shown in FIGs. 28B and 28C. The slit structures 2840, 2842, 2844 penetrate vertically through the film stack 2820 in the Z direction. In some implementations, the slit structures 2840, 2842 and 2844 extend into the substrate 1110. Each functional tier 2825 (similar to the functional tier 425 in FIG. 4) includes the first dielectric layer 1122, the conductive layer 2770, 2772, and the un-etched second dielectric layer 1124, where the conductive layer 2770, 2772, and the un-etched second dielectric layer 1124 are coplanar in each functional tier 2825. The conductive layers 2770 and 2772 are electrically isolated by the slit structures 2840, 2842, 2844, trench isolations 2564 and the un-etched (remaining) second dielectric layers 1124 and form the common source line and the common bit line, respectively. In the X-Y plane, the common source lines and common bit lines for the channel structures 1770 are disposed symmetrically along the slit structure 2840 in between the two rows of channel structures. That is, in a same tier, adjacent rows of channel structures can share a same common source line or a same common bit line.

Referring to FIGs. 28A-28C, for each memory block 2780, the common source line and the common bit line of each functional tier 2825 can be electrically connected through the staircase contact pads 2360 in the left and right staircase regions 1230, respectively. The control gate 1710 of each channel structure 1770 can be electrically connected from top of the channel structure 1770 and can be connected to word lines (not shown in FIG. 28A) running in the X direction.

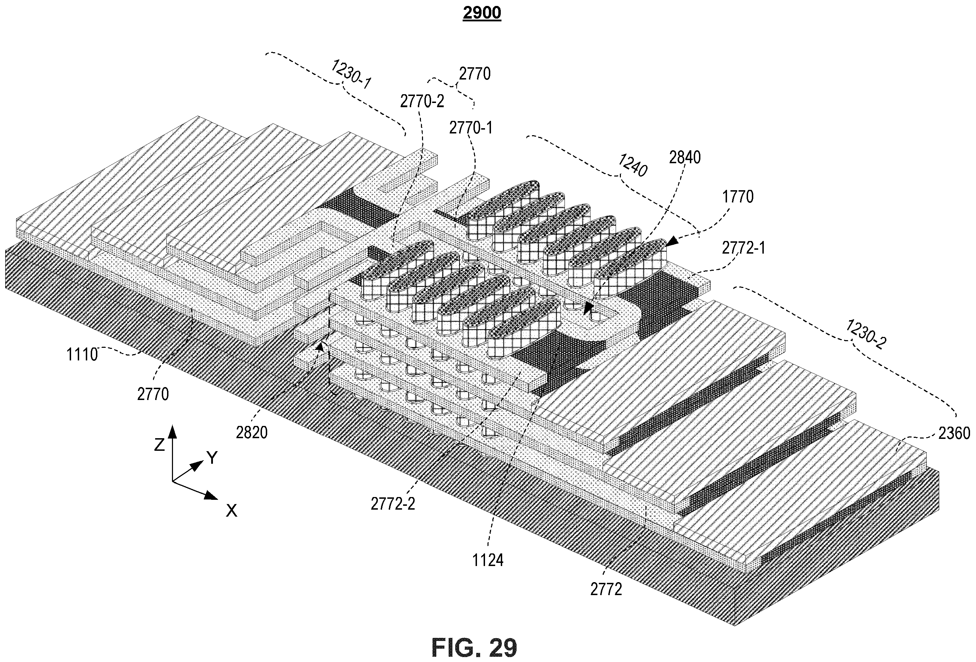

FIG. 29 illustrates a perspective view of a three-dimensional (3D) ferroelectric memory device. The 3D ferroelectric memory device 2900 can be similar to the memory structures and devices described in the present disclosure, for example, the 3D ferroelectric memory device 2800 in FIG. 28, the memory array structure 400 in FIG. 4 and the memory device in FIG. 21.

As shown in FIG. 29, the 3D ferroelectric memory device 2900 includes two staircase regions 1230 (including 1230-1 and 1230-2) and the array core region 1240 in between. In the array core region 1240, the 3D ferroelectric memory device 2900 include a film stack 2820 (see also FIGs. 4, 28B and 28C) and channel structures 1770 extending vertically through the film stack 2820. The film stack 2820 includes functional tiers stacked in the Z direction, each functional tier 2825 (see also FIGs. 4 (item 425), 28B and 28C) including the first dielectric layer 1122 (omitted in FIG. 29 for simplicity) and the conductive layer 2770, 2772. At each tier, the right portion of the conductive layers 2772 (including 2772-1 and 2772-2) contact the staircase contact pad 2360 in the right staircase region 1230-2. At each tier, the left portion of the conductive layers 2770 (including 2770-1 and 2770-2) contact the staircase contact pad 2360 in the left staircase region 1230-1. Each tier also includes the second dielectric layer 1124 providing electrical isolations between the left portion of the conductive layer 2770 and the right portion of the conductive layer 2772. In some implementations, the second dielectric layer 1124 is coplanar with the conductive layer 2770, 2772 at each tier.

The channel structures 1770 are in oval shapes in the X-Y plane. Each channel structure includes the control gate 1710 (see also FIGs. 17A-17B and 28B-28C) in a center, where the control gate 1710 is surrounded by the memory film 1660 that include a ferroelectric film. The memory film 1660 is surrounded by the channel layer 1551. The control gate 1710 and the memory film 1660 extend vertically through the film stack 2820, where the channel layer 1151 can be disconnected by the first dielectric layers 1122 in the vertical direction (see FIGs. 17A, 28B and 28C). The intersection between the control gate 1710, the memory film 1660 and the channel layer 1151 at each tier forms the memory cell 1772 (see also FIGs. 17A, 28B-28C).

In FIG. 29, one memory block is illustrated for the 3D ferroelectric memory device 2900, which includes two rows of channel structures 1770, each row including six channel structures. In the X-Y plane, common source lines and common bit lines for the channel structures 1770 are disposed symmetrically along the slit structure 2840 (filling material is omitted in FIG. 29) in between the two rows of channel structures. The two rows of channel structures 1770 forms a memory block by the slit structures along X direction (not shown in FIG. 29) extending across the left staircase region 1230-1, the array core region 1240 and the right staircase region 1230-2. First ends of the channel structures 1770 in a first row contact the right portion of the conductive layer 2772-1 and second ends of the channel structures 1770 in the first row contact the left portion of the conductive layer 2770-1. First ends of the channel structures 1770 in a second row contact the left portion of the conductive layer 2770-2 and second ends of the channel structures 1770 in the second row contact the right portion of the conductive layer 2772-2. The left portion of the conductive layers 2770-1 and 2770-2 can be connected with each other physically. The right portion of the conductive layers 2772-1 and 2772-2 can be electrically connected with each other through the staircase contact pad 2360 in the right staircase region 1230-2.

As such, the 3D ferroelectric memory device 2900 can provide the common source line and common bit line for each memory cell at each tier.

Accordingly, three-dimensional (3D) Ferroelectric Field Effect Transistor (FeFET) Random Access Memory (RAM) devices, and fabricating methods thereof are described in the present disclosure. The disclosed 3D FeFET RAM devices are high-speed, high-density non-volatile memories by using ferroelectric polarity to change threshold voltage and store data. The graphical of the memory cells can be designed to be oval shape to increase the gate length for increasing gate control capability while increasing storage density. Further, the common source line and the common bit line can be formed to implement random access to each memory cell.

It is noted that the number and layout of the channel structures, trench isolations, slit structures and common source/bit lines throughout the present disclosure are not limited to the examples shown in the Figures and not limited to the descriptions therein. Any suitable number and layout and associated variations are within the scope of the present disclosure.

To summarize, the present disclosure provides a memory device that includes a film stack having functional tiers stacked in a first direction. Each functional tier includes a first dielectric layer and a conductive layer. The memory device also includes channel structures disposed in an array core region, wherein each channel structure extends through the film stack in the first direction. Each channel structure includes a control gate in a center, a memory film that is disposed on a sidewall of the control gate and includes a ferroelectric film. Each channel structure also includes a channel layer disposed on a sidewall of the memory film.

The present disclosure also provides a method for forming a ferroelectric memory device. The method includes forming a dielectric stack, wherein the dielectric stack comprises first dielectric layers and second dielectric layers alternatingly stacked in a first direction; forming a channel hole in the dielectric stack in an array core region; and forming a channel structure in the channel hole. The forming of the channel structure includes forming a channel layer on a sidewall of the channel hole; forming a memory film on a sidewall of the channel layer, wherein the memory film comprises a ferroelectric film; and forming a control gate on a sidewall of the memory film.

The foregoing description of the specific implementations will so fully reveal the general nature of the present disclosure that others can, by applying knowledge within the skill of the art, readily modify and/or adapt, for various applications, such specific implementations, without undue experimentation, and without departing from the general concept of the present disclosure. It is to be understood that the phraseology or terminology herein is for the purpose of description and not of limitation, such that the terminology or phraseology of the present specification is to be interpreted by the skilled artisan in light of the disclosure and guidance.

Implementations of the present disclosure have been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

The Summary and Abstract sections can set forth one or more but not all exemplary implementations of the present disclosure as contemplated by the inventor(s), and thus, are not intended to limit the present disclosure and the appended claims in any way.

The breadth and scope of the present disclosure should not be limited by any of the above-described exemplary implementations, but should be defined only in accordance with the following claims.

## Claims

1. A ferroelectric memory device (2800), comprising:
a film stack (420) comprising functional tiers (425) stacked in a first direction, each functional tier (425) comprising a first dielectric layer (432) and a conductive layer (440); and
channel structures (480) disposed in an array core region, wherein each channel structure (480) extends through the film stack (420) in the first direction and comprises:
a control gate (210, 510) in a center;
a memory film (220) disposed on a sidewall of the control gate (210, 510) and comprising a ferroelectric film (224, 524); and
a channel layer (230, 530) disposed on a sidewall of the memory film (220), wherein each functional tier (425) further comprises a second dielectric layer (434), wherein the second dielectric layer (434) separates the conductive layer (440) into a first portion and a second portion that is electrically isolated from the first portion, wherein in a second direction that is perpendicular to the first direction, a first end and a second end of the channel layer (230, 530) contact the first portion and the second portion of the conductive layer (440), respectively.

2. The memory device of claim 1, wherein the control gate (210, 510) and the memory film (220) extend through the film stack (420) in the first direction, and the channel layer (230, 530) is disconnected in the first direction by the first dielectric layer (432) of each functional tier (425).

3. The memory device of claim 1, wherein the memory film (220) further comprises:
a barrier layer disposed between the control gate (210, 510) and the ferroelectric film (224, 524); and an interface layer disposed between the ferroelectric film (224, 524) and the channel layer (230, 530).

4. The memory device of claim 1, wherein the second dielectric layer (434) is coplanar with the conductive layer (440) and the channel layer (230, 530).

5. The memory device of claim 1, further comprising:
a first staircase structure and a second staircase structure disposed in the film stack (420) on opposite sides of the array core region, wherein each functional tier (425) of the film stack (420) corresponds to a first step of the first staircase structure and a second step of the second staircase structure.

6. The memory device of claim 5, wherein the first step of the first staircase structure is configured to provide electrical connection to the first portion of the conductive layer (440) and the second step of the second staircase structure is configured to provide electrical connection to the second portion of the conductive layer (440).

7. The memory device of claim 6, further comprising:
staircase contact pads disposed on the first step of the first staircase structure and the second step of the second staircase structure, wherein each of the staircase contact pads contacts a portion of the second dielectric layer (434) and a portion of the conductive layer (440).

8. The memory device of claim 1, further comprising:
a slit structure extending through the film stack (420) in the first direction, wherein the slit structure is disposed between adjacent rows of channel structures (480).

9. The memory device of claim 8, wherein the slit structure extends in a second direction perpendicular to the first direction and are configured to separate the channel structures (480) into different memory blocks, wherein each memory block comprises one or more rows of channel structures (480).

10. The memory device of claim 8, further comprising:
a trench isolation extending through the film stack (420) in the first direction, wherein the trench isolation extending in a third direction that is perpendicular to the first direction and the second direction.

11. The memory device of claim 10, wherein the trench isolation is connected with the second dielectric layer (434) of each functional tier (425).

12. A method for forming the ferroelectric memory device according to claims 1-11, comprising:
forming a dielectric stack, wherein the dielectric stack comprises first dielectric layers (432) and second dielectric layers (434) alternatingly stacked in a first direction;
forming a channel hole in the dielectric stack in an array core region; and
forming a channel structure (480) in the channel hole, comprising:
forming a channel layer (230, 530) on a sidewall of the channel hole;
forming a memory film (220) on a sidewall of the channel layer (230, 530), wherein the memory film (220) comprises a ferroelectric film (224, 524); and
forming a control gate (210, 510) on a sidewall of the memory film (220), wherein the forming of the channel layer (230, 530) comprises:
removing portions of the second dielectric layers (434) of the dielectric stack that are exposed by the channel hole to form recesses on the sidewall of the channel hole; and
disposing the channel layer (230, 530) in the recesses on the sidewall of the channel hole.

13. The method of claim 12, wherein the forming of the channel layer (230, 530) further comprises removing portions of the channel layer (230, 530) on sidewalls of the first dielectric layers (432).

14. The method of claim 12, further comprising:
forming a slit opening in the dielectric stack, wherein the slit opening extends in a second direction perpendicular to the first direction and is disposed between adjacent rows of channel structures (480); and
replacing portions of the second dielectric layers (434) exposed by the slit opening with conductive
layers.

15. The method of claim 14, further comprising:
prior to forming the slit opening, forming a trench isolation in the dielectric stack, wherein the trench isolation extends in a third direction perpendicularly to the first direction and the second direction, wherein the trench isolation and the slit opening are configured to separate the conductive layer (440) of each functional tier (425) into a first portion and a second portion that is electrically isolated from the first portion, preferably further comprising:
prior to forming the slit opening, forming a first staircase structure and a second staircase structure in the dielectric stack on opposite sides of the array core region; and
forming a first staircase contact pad on each step of the first staircase structure and a second staircase contact pad on each step of the second staircase structure, wherein the first staircase contact pad of the first staircase structure is connected with the first portion of the conductive layer (440) and the second staircase contact pad of the second staircase structure is connected with the second portion of the conductive layer (440).

## Patentansprüche

1. Ferroelektrische Speichervorrichtung (2800), umfassend:
einen Folienstapel (420) mit in einer ersten Richtung gestapelten Funktionsebenen (425), wobei jede Funktionsebene (425) eine erste dielektrische Schicht (432) und eine leitende Schicht (440) umfasst; und
in einem Array-Kern-Bereich angeordnete Kanalstrukturen (480), wobei sich jede Kanalstruktur (480) in der ersten Richtung durch den Folienstapel (420) erstreckt und umfasst:
ein Control Gate (210, 510) in einer Mitte;
eine Speicherfolie (220), die an einer Seitenwand des Control Gates (210, 510) angeordnet ist und eine ferromagnetische Folie (224, 524) umfasst; und
eine Kanalschicht (230, 530), die an einer Seitenwand der Speicherfolie (220) angeordnet ist, wobei jede Funktionsebene (425) ferner eine zweite dielektrische Schicht (434) umfasst, wobei die zweite dielektrische Schicht (434) die leitende Schicht (440) in einen ersten Abschnitt und einen vom ersten Abschnitt elektrisch isolierten zweiten Abschnitt aufteilt, wobei in einer zur ersten Richtung senkrechten zweiten Richtung ein erstes Ende und ein zweites Ende der Kanalschicht (230, 530) jeweils den ersten Abschnitt und den zweiten Abschnitt der leitenden Schicht (440) kontaktieren.

2. Speichervorrichtung nach Anspruch 1, wobei sich das Control Gate (210, 510) und die Speicherfolie (220) in der ersten Richtung durch den Folienstapel (420) erstrecken und die Kanalschicht (230, 530) durch die erste dielektrische Schicht (432) jeder Funktionsebene (425) unterbrochen ist.

3. Speichervorrichtung nach Anspruch 1, wobei die Speicherfolie (220) ferner umfasst:
eine Sperrschicht, die zwischen dem Control Gate (210, 510) und der ferroelektrischen Folie (224, 524) angeordnet ist; und eine Schnittstellenschicht, die zwischen der ferroelektrischen Folie (224, 524) und der Kanalschicht (230, 530) angeordnet ist.

4. Speichervorrichtung nach Anspruch 1, wobei die zweite dielektrische Schicht (434) mit der leitenden Schicht (440) und der Kanalschicht (230, 530) koplanar ist.

5. Speichervorrichtung nach Anspruch 1, ferner umfassend:
eine erste Treppenstruktur und eine zweite Treppenstruktur, die in dem Folienstapel (420) auf gegenüberliegenden Seiten des Array-Kern-Bereichs angeordnet sind, wobei jede Funktionsebene (425) des Folienstapels (420) einer ersten Stufe der ersten Treppenstruktur und einer zweiten Stufe der zweiten Treppenstruktur entspricht.

6. Speichervorrichtung nach Anspruch 5, wobei die erste Stufe der ersten Treppenstruktur konfiguriert ist für die Bereitstellung einer elektrischen Verbindung mit dem ersten Abschnitt der leitenden Schicht (440) und die zweite Stufe der zweiten Treppenstruktur konfiguriert ist für die Bereitstellung einer elektrischen Verbindung mit dem zweiten Abschnitt der leitenden Schicht (440).

7. Speichervorrichtung nach Anspruch 6, ferner umfassend:
Treppen-Kontaktpads, die an der ersten Stufe der ersten Treppenstruktur und an der zweiten Stufe der zweiten Treppenstruktur angeordnet sind, wobei jedes der Treppen-Kontaktpads einen Abschnitt der zweiten dielektrischen Schicht (434) und einen Abschnitt der leitenden Schicht (440) kontaktiert.

8. Speichervorrichtung nach Anspruch 1, ferner umfassend:
eine sich in der ersten Richtung durch den Folienstapel (420) erstreckende Schlitzstruktur, wobei die Schlitzstruktur zwischen benachbarten Reihen von Kanalstrukturen (480) angeordnet ist.

9. Speichervorrichtung nach Anspruch 8, wobei sich die Schlitzstruktur in einer zur ersten Richtung senkrechten zweiten Richtung erstreckt und konfiguriert ist zum Aufteilen der Kanalstrukturen (480) in verschiedene Speicherblöcke, wobei jeder Speicherblock eine oder mehrere Reihen von Kanalstrukturen (480) umfasst.

10. Speichervorrichtung nach Anspruch 8, ferner umfassend:
eine sich in der ersten Richtung durch den Folienstapel (420) erstreckende Grabenisolation, wobei sich die Grabenisolation in einer zur ersten Richtung und zur zweiten Richtung senkrechten dritten Richtung erstreckt.

11. Speichervorrichtung nach Anspruch 10, wobei die Grabenisolation mit der zweiten dielektrischen Schicht (434) jeder Funktionsebene (425) verbunden ist.

12. Verfahren zur Herstellung der ferroelektrischen Speichervorrichtung gemäß den Ansprüchen 1 bis 11, umfassend:
Bilden eines dielektrischen Stapels, wobei der dielektrische Stapel erste dielektrische Schichten (432) und zweite dielektrische Schichten (434) umfasst, die in einer ersten Richtung alternierend gestapelt sind;
Bilden eines Kanal-Lochs in dem dielektrischen Stapel in einem Array-Kern-Bereich; und
Bilden einer Kanalstruktur (480) in dem Kanal-Loch, umfassend:
Ausbilden einer Kanalschicht (230, 530) an einer Seitenwand des Kanal-Lochs;
Ausbilden einer Speicherfolie (220) an einer Seitenwand der Kanalschicht (230, 530), wobei die Speicherfolie (220) eine ferroelektrische Folie (224, 524) umfasst; und
Bilden eines Control Gates (210, 510) an einer Seitenwand der Speicherfolie (220), wobei das Ausbilden der Kanalschicht (230, 530) umfasst:
Entfernen von Teilen der zweiten dielektrischen Schichten (434) des dielektrischen Stapels, die durch das Kanal-Loch freigelegt werden, um Vertiefungen an der Seitenwand der Kanalöffnung zu bilden; und
Anordnen der Kanalschicht (230, 530) in den Vertiefungen an der Seitenwand der Kanalöffnung.

13. Verfahren nach Anspruch 12, wobei das Ausbilden der Kanalschicht (230, 530) ferner das Entfernen von Teilen der Kanalschicht (230, 530) an Seitenwänden der ersten dielektrischen Schichten (432) umfasst.

14. Verfahren nach Anspruch 12, ferner umfassend:
Bilden einer Schlitzöffnung in dem dielektrischen Stapel, wobei sich die Schlitzöffnung in einer zur ersten Richtung senkrechten zweiten Richtung erstreckt und zwischen benachbarten Reihen von Kanalstrukturen (480) angeordnet ist; und
Ersetzen von Abschnitten der zweiten dielektrischen Schichten (434), die durch die Schlitzöffnung freigelegt sind, durch leitende Schichten.

15. Verfahren nach Anspruch 14, ferner umfassend:
Bilden einer Grabenisolation in dem dielektrischen Stapel vor dem Bilden der Schlitzöffnung, wobei sich die Grabenisolation in einer zur ersten Richtung und zur zweiten Richtung senkrechten dritten Richtung erstreckt, wobei die Grabenisolation und die Schlitzöffnung derart konfiguriert sind, dass sie die leitende Schicht (440) jeder Funktionsebene (425) in einen ersten Abschnitt und einen von dem ersten Abschnitt isolierten zweiten Abschnitt aufteilen, vorzugsweise ferner umfassend:
Bilden einer ersten Treppenstruktur und einer zweiten Treppenstruktur in dem dielektrischen Stapel auf gegenüberliegenden Seiten des Array-Kern-Bereichs vor dem Bilden der Schlitzöffnung; und
Bilden eines ersten Treppen-Kontaktpads an jeder Stufe der Treppenstruktur und eines zweiten Treppen-Kontaktpads an jeder Stufe der zweiten Treppenstruktur, wobei das erste Treppen-Kontaktpad der ersten Treppenstruktur mit dem ersten Abschnitt der leitenden Schicht (440) und das zweite Treppen-Kontaktpad der zweiten Treppenstruktur mit dem zweiten Abschnitt der leitenden Schicht (440) verbunden ist.

## Revendications

1. Dispositif de mémoire ferroélectrique (2800) comprenant:
un empilement de feuilles (420) comportant des niveaux fonctionnels (425) empilés dans une première direction, chaque niveau fonctionnel (425) comprenant une première couche diélectrique (432) et une couche conductrice (440); et
des structures de canal (480) disposées dans une zone centrale de matrice, chaque structure de canal (480) s'étendant dans la première direction à travers l'empilement de feuilles (420) et comprenant:
une grille de contrôle (210, 510) dans un centre;
une feuille de mémoire (220) disposée sur une paroi latérale de la grille de contrôle (210, 510) et comprenant une feuille ferromagnétique (224, 524); et
une couche de canal (230, 530) disposée sur une paroi latérale de la feuille de mémoire (220), chaque niveau fonctionnel (425) comprenant en outre une deuxième couche diélectrique (434), la deuxième couche diélectrique (434) séparant la couche conductrice (440) en une première partie et une deuxième partie isolée électriquement de la première partie, une première extrémité et une deuxième extrémité de la couche de canal (230, 530) étant respectivement en contact avec la première partie et la deuxième partie de la couche conductrice (440) dans une deuxième direction perpendiculaire à la première direction.

2. Dispositif de mémoire selon la revendication 1, dans lequel la grille de contrôle (210, 510) et la feuille de mémoire (220) s'étendent dans la première direction à travers l'empilement de feuilles (420), et la couche de canal (230, 530) est déconnectée par la première couche diélectrique (432) de chaque niveau fonctionnel (425).

3. Dispositif de mémoire selon la revendication 1, dans lequel la feuille de mémoire (220) comprend en outre:
une couche barrière disposée entre la grille de contrôle (210, 510) et la feuille ferroélectrique (224, 524); et une couche d'interface disposée entre la feuille ferroélectrique (224, 524) et la couche de canal (230, 530).

4. Dispositif de mémoire selon la revendication 1, dans lequel la deuxième couche diélectrique (434) est coplanaire avec la couche conductrice (440) et la couche de canal (230, 530).

5. Dispositif de mémoire selon la revendication 1, comprenant en outre:
une première structure en escalier et une deuxième structure en escalier, qui sont disposées dans l'empilement de feuilles (420) sur des côtés opposés de la zone centrale de la matrice, chaque niveau fonctionnel (425) de l'empilement de feuilles (420) correspondant à un premier échelon de la première structure en escalier et à un deuxième échelon de la deuxième structure en escalier.

6. Dispositif de mémoire selon la revendication 5, dans lequel le premier échelon de la première structure en escalier est configuré pour établir une connexion électrique avec la première partie de la couche conductrice (440) et le deuxième échelon de la deuxième structure en escalier est configuré pour établir une connexion électrique avec la deuxième partie de la couche conductrice (440).

7. Dispositif de mémoire selon la revendication 6, comprenant en outre:
des plots de contact de l'escalier disposés sur la première marche de la première structure en escalier et sur la deuxième marche de la deuxième structure en escalier, chacun des plots de contact de l'escalier étant en contact avec une partie de la deuxième couche diélectrique (434) et une partie de la couche conductrice (440).

8. Dispositif de mémoire selon la revendication 1, comprenant en outre:
une structure à fentes s'étendant dans la première direction à travers l'empilement de feuilles (420), ladite structure à fentes étant disposée entre des rangées adjacentes de structures en canaux (480).

9. Dispositif de mémoire selon la revendication 8, dans lequel la structure à fentes s'étend dans une deuxième direction perpendiculaire à la première direction et est configurée pour séparer les structures de canaux (480) en différents blocs de mémoire, chaque bloc de mémoire comprenant une ou plusieurs rangées de structures de canaux (480).

10. Dispositif de mémoire selon la revendication 8, comprenant en outre:
une isolation de tranchée s'étendant dans la première direction à travers l'empilement de feuilles (420), l'isolation de tranchée s'étendant dans une troisième direction perpendiculaire à la première direction et à la deuxième direction.

11. Dispositif de mémoire selon la revendication 10, dans lequel l'isolation de tranchée est reliée à la deuxième couche diélectrique (434) de chaque niveau fonctionnel (425).

12. Procédé de fabrication du dispositif de mémoire ferroélectrique selon les revendications 1 à 11, comprenant:
la formation d'un empilement diélectrique, ledit empilement diélectrique comprenant des premières couches diélectriques (432) et des deuxièmes couches diélectriques (434) empilées en alternance dans une première direction;
la formation d'un trou de canal dans l'empilement diélectrique dans une zone centrale de matrice; et
la formation d'une structure de canal (480) dans le trou de canal, comprenant:
la formation d'une couche de canal (230, 530) sur une paroi latérale du trou de canal;
la formation d'une feuille de mémoire (220) sur une paroi latérale de la couche de canal (230, 530), la feuille de mémoire (220) comprenant une feuille ferroélectrique (224, 524); et
la formation d'une grille de contrôle (210, 510) sur une paroi latérale de la feuille de mémoire (220), la formation de la couche de canal (230, 530) comprenant:
l'enlèvement de parties des deuxièmes couches diélectriques (434) de l'empilement diélectrique qui sont mises à nu par le trou de canal, afin de former des creux sur la paroi latérale du trou de canal; et
la disposition de la couche de canal (230, 530) dans les creux sur la paroi latérale du trou de canal.

13. Procédé selon la revendication 12, dans lequel la formation de la couche de canal (230, 530) comprend en outre l'enlèvement de parties de la couche de canal (230, 530) au niveau des parois latérales des premières couches diélectriques (432).

14. Procédé selon la revendication 12, comprenant en outre:
la formation d'une ouverture en fente dans l'empilement diélectrique, l'ouverture en fente s'étendant dans une deuxième direction perpendiculaire à la première direction et étant disposée entre des rangées adjacentes de structures de canaux (480); et
le remplacement de parties des deuxièmes couches diélectriques (434) mises à nu par l'ouverture en fente par des couches conductrices.

15. Procédé selon la revendication 14, comprenant en outre:
la formation d'une isolation en tranchée dans l'empilement diélectrique avant la formation de l'ouverture en fente, l'isolation en tranchée s'étendant dans une troisième direction perpendiculaire à la première direction et à la deuxième direction, l'isolation en tranchée et l'ouverture en fente étant configurées de manière à séparer la couche conductrice (440) de chaque niveau fonctionnel (425) en une première partie et une deuxième partie isolée de la première partie, comprenant de préférence en outre:
la formation d'une première structure en escalier et d'une deuxième structure en escalier dans l'empilement diélectrique sur des côtés opposés de la zone centrale de matrice avant la formation de l'ouverture en fente; et
la formation d'un premier plot de contact de l'escalier sur chaque marche de la structure en escalier et d'un deuxième plot de contact de l'escalier sur chaque marche de la deuxième structure en escalier, le premier plot de contact de l'escalier de la première structure en escalier étant connecté à la première partie de la couche conductrice (440) et le deuxième plot de contact de l'escalier de la deuxième structure en escalier étant connecté à la deuxième partie de la couche conductrice (440).
